(19) Europäisches Patentamt
European Patent Office
Office européen des brevets

(11) **EP 3 049 193 B1**

(12) **EUROPÄISCHE PATENTSCHRIFT**

(45) Veröffentlichungstag und Bekanntmachung des Hinweises auf die Patenterteilung:
**08.09.2021   Patentblatt 2021/36**

(21) Anmeldenummer: **14772359.7**

(22) Anmeldetag: **25.09.2014**

(51) Int Cl.:
**B05D 7/14** (2006.01)          **B05D 1/00** (2006.01)
**B05D 5/08** (2006.01)

(86) Internationale Anmeldenummer:
**PCT/EP2014/070449**

(87) Internationale Veröffentlichungsnummer:
**WO 2015/044247 (02.04.2015 Gazette 2015/13)**

(54) **PLASMAPOLYMERER FESTKÖRPER (INSBESONDERE PLASMAPOLYMERE SCHICHT)**

SOLID PLASMA POLYMER BODY (IN PARTICULAR PLASMA POLYMER LAYER)

CORPS SOLIDE DE POLYMÈRE DE PLASMA (EN PARTICULIER COUCHE DE POLYMÈRE DE PLASMA)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.09.2013   DE 102013219331**
**25.09.2013   DE 102013219337**

(43) Veröffentlichungstag der Anmeldung:
**03.08.2016   Patentblatt 2016/31**

(73) Patentinhaber: **Fraunhofer-Gesellschaft zur Förderung der angewandten Forschung e.V.**
**80686 München (DE)**

(72) Erfinder:
• **VISSING, Klaus-Dieter**
**27321 Thedinghausen (Morsum) (DE)**
• **OTT, Matthias**
**21255 Dohren (DE)**
• **GRASSL, Gregor**
**21684 Stade (DE)**
• **HIELSCHER, Wolfgang**
**28757 Bremen (DE)**

(74) Vertreter: **Eisenführ Speiser**
**Patentanwälte Rechtsanwälte PartGmbB**
**Postfach 10 60 78**
**28060 Bremen (DE)**

(56) Entgegenhaltungen:
**EP-B1- 1 301 286          WO-A1-2010/125178**
**DE-A1-102005 059 706     DE-A1-102009 000 699**
**US-B1- 7 622 400**

Bemerkungen:
Die Akte enthält technische Angaben, die nach dem Eingang der Anmeldung eingereicht wurden und die nicht in dieser Patentschrift enthalten sind.

EP 3 049 193 B1

**Beschreibung**

Die Erfindung betrifft einen plasmapolymeren Festkörper, insbesondere eine plasmapolymere Schicht, die bei einem gegebenen C/O-Verhältnis über einen außergewöhnlich hohen E-Modul verfügt. Sie betrifft ferner einen Festkörper, umfassend ein Substrat und auf dieses Substrat aufgebracht eine erfindungsgemäße plasmapolymere Schicht sowie die Verwendung einer plasmapolymeren Schicht als Trennschicht in einem Formwerkzeug und auch die Verwendung einer erfindungsgemäßen Schicht zur Verbesserung der Reinigungsfähigkeit eines Festkörpers mit Wasser oder anderen Reinigungsmedien. Sie betrifft ferner die Verwendung einer plasmapolymeren Schicht als Korrosionsschutz auf einem Metall- oder Metalllegierungssubstrat und auch die Verwendung einer erfindungsgemäßen Schicht zur Verbesserung der Reinigungsfähigkeit eines Festkörpers, der Metall an seiner Oberfläche besitzt, mit wässrigen oder anderen Reinigungsmedien.

Für industrielle Anwendungen, aber auch im Privatbereich besteht ein ständiger Bedarf an optimierten Oberflächen für eine Vielzahl von Zwecken. Dabei sind die Eigenschaften, die optimiert sein sollen, selbstverständlich abhängig vom Einsatzzweck: So bestimmt der jeweilige Einsatzzweck, welche Bereiche für Parameter wie zum Beispiel Härte, Dehnbarkeit und/oder Oberflächenenergie besonders wünschenswert sind. Dabei ist es in vielen Fällen besonders anspruchsvoll, für die genannten und gegebenenfalls weitere Parameter Verbesserungen zu erzielen, ohne dass sich ein anderer (wichtiger) Parameter aus Sicht des Anwendungszwecks verschlechtert oder wenigstens zu sehr verschlechtert.

Bekannte Oberflächenveredelungsverfahren sind beispielsweise den Dokumenten WO2010/125178 A1, DE102009000699 A1, EP1301286 B1 und US7622400 B1 zu entnehmen.

Besonders hohe Ansprüche, insbesondere auch an die vorgenannten Parameter, bestehen für Formgebungsverfahren für faserverstärkte Kunststoffe bei der Entformung. Dies ist wichtig für einen ersten Aspekt der vorliegenden Erfindung.

Faserverstärkte Kunststoffe (FVK) bestehen aus matrixgebundenen Fasern, die schichtweise aufgebaut sein können. Die Fasern können orientiert, unorientiert oder gewebt sein. Weiterhin können die Fasern aus unterschiedlichen Materialien bestehen, wie etwa Glasfasern, Kohlenstofffasern, Aramidfasern, Borfasern, Naturfasern oder Holz. Die einzelnen Schichten können aus unterschiedlichen Materialien bestehen. So sind auch Metallgewebe, Schäume, dreidimensionale Strukturplatten, wie etwa Waben oder Holz zum Aufbau von Faserverbundwerkstoffen geeignet. Die Matrix besteht üblicherweise aus einem Thermoplasten oder einem Reaktionsharz, welches thermisch gehärtet werden kann. Reaktionsharze sind etwa Polyester-, Vinylester- oder Epoxidharze, Melamin oder Phenol-Formaldehydharze.

Die bekanntesten Verfahren zur Herstellung von faserverstärkten Kunststoffen sind das Handlaminieren, (Vakuum-)Infusionverfahren, Prepregverfahren, Faserwickeln, Faserspritzen, Spritzgussverfahren, Injektionsverfahren wie Resin Transfer Molding (RTM), Nasspressverfahren, beispielsweise zur Herstellung von Sheet Molding Compounds (SMC) oder mit Hilfe thermoplastischer Organobleche.

Üblicherweise werden FVK-Bauteile zumindest einseitig auf einer Form hergestellt. Damit das Bauteil nach dem Fertigungsprozess von der Form gelöst werden kann, werden heutzutage überwiegend vor dem Fertigen Trennmittel auf die Formoberfläche aufgebracht. Je nach Fertigungsverfahren werden auf die Form anschließend üblicherweise vorimprägnierte Fasern (z.B. Prepregs), Trockenfasern, Abreißgewebe (Peel Ply), andere Hilfsmaterialien (wie imprägniertes Kupfergitter als Blitzschutz) oder auch Inmold-Lacke (IMC, In-Mold-Coating) aufgebracht. Bei den Trockenfaser-Verfahren wird in einem weiteren Schritt das Matrixharz flüssig zugeführt. Am Ende wird bei duroplastischen FVK das Matrixharz ausgehärtet, wobei die Form häufig aufgeheizt wird. Bei thermoplastischen FVK wird das Polymer ebenfalls erhitzt, um eine Umformung, bzw. eine Formgebung zu erreichen.

Eine typische Applikation eines IMC-Lacks ist dabei die Auftragung als Gelcoat beispielsweise händisch mit Hilfe einer Rolle. Der IMC-Lack wird üblicherweise zunächst teilweise ausgehärtet, anschließend wird der übliche FVK-Aufbau vorgenommen und erst bei der Aushärtung des Matrix-Harzes erhält der IMC-Lack seine Endhärte.

Nach dem Aushärten, bzw. Umformen oder Urformen wird das Werkstück mit Hilfe der zuvor aufgetragenen Trennmittel entformt. Auf diese Weise können z. B. Teile für Segelflugzeuge, Rotorblätter für Windanlagen, Bootsrümpfe, Kfz-Teile, Rohre, Schwimmbecken und vieles mehr hergestellt werden.

In allen diesen Verfahren ist es von großer Bedeutung und unumgänglich, die Form vor dem Kontakt mit der ersten Gelcoat- oder Harzschicht mit einem Trennmittel vollflächig zu behandelt, um eine fehlerfreie und einfache Entformung des Werkstückes zu ermöglichen. Diese Trennmittel verbleiben nach der Entformung sowohl auf dem Kunststoff-Formteil als auch auf der Formoberfläche. Dadurch müssen die Formteile und die Formen häufig aufwändig von den Trennmittelrückständen befreit werden. Zudem werden die Formteile teilweise klebtechnisch gefügt und/oder lackiert, was eine wirksame und daher sehr aufwändig Entfernung von Trennmitteln und lückenlose Qualitätssicherung erfordert.

Seit vielen Jahren ist man daher bemüht Trennmittel aus der Produktion von Formteilen aus Kunststoff zu eliminieren, denn eine trennmittelfreie Produktion ist effektiver, kostengünstiger, sauberer und umweltfreundlicher. Doch stehen den Entwicklern und Erfindern große Probleme im Wege, die bisher eine schnelle und breit gefächerte Umsetzung dieser Zielsetzung unmöglich gemacht haben. Hierzu gehören die unterschiedlichen zu entformenden Kunststoffe mit ihren jeweiligen Zuschlagstoffen, ihre unterschiedlichen Aushärtereaktionen und Verarbeitungsbedingungen.

Zusätzlich erschwert wird diese Situation sowohl durch die Verwendung einer Vielzahl ganz unterschiedlicher Fertigungsverfahren, um Bauteile der unterschiedlichsten Formen zu fertigen, als auch durch die Tatsache, dass aus ökonomischen Gründen vielfach eine Entformung vor der vollständigen Aushärtung des Produktes erfolgen soll.

Trennmittel werden primär zur Herstellung von Bauteilen aus reaktiven Kunststoffen eingesetzt. Hierzu gehören Bauteile aus Polyurethan (PUR), Epoxidharzen (EP), Phenol-Formaldehydharzen, Polyesterharzen, ABS-Harzen, Melaminharzen, Polyamidharzen, Venylesterharzen, Alkydharzen, Silikonen oder weiteren Vergussmassen. Daneben werden Trennmittel vereinzelt bei der Herstellung von Thermoplastbauteilen, z.B. Organoblechen, benutzt. Hier dienen sie, im Gegensatz zu den reaktiven Kunststoffen, nur zur Reduktion von physikalischen Wechselwirkungskräften (z.B. van-der-Waals-Kräften, Wasserstoffbrückenbindungen).

Unabhängig vom verwendeten Kunststoff, wie auch unabhängig davon, ob das Trennmittel extern oder als internes Trennmittel zugeführt wurde, zeichnet es sich dadurch aus, dass es beim Entformen zu einem Kohäsionsbruch innerhalb des Trennmittels kommt. Dies ist der Grund für die Nachteile, die ein Trennmittel mit sich bringen kann.

Daher ist es keine sinnvolle Lösung ein Trennmittel mit einer Entformungsschicht zu kombinieren. Es ist allenfalls eine Erleichterung bei der Formenreinigung.

Alle technischen Ansätze, konsequent auf Trennmittel zu verzichten, kann man grundsätzlich in zwei Kategorien unterteilen:

    1. Einleger Technologie, bei der Folien oder spritzgegossene Einsätze in die Form gelegt werden.

    2. Formbeschichtungstechnologie, bei der eine direkte, haftfeste Beschichtung der Form mit einer Trennschicht erfolgt.

Typische Einleger-Technologien sind:

- Foam and Film Technologie von Canon

- PURe-Liner von Frimo (siehe auch DE 10 2009 054 893 A1)

- Folieneinleger aus Fluorpolymeren (z.B. ETFE, PTFE)

- plasmapolymer beschichtete Polymerfolien Flex$^{PLAS}$ (DE 10 2012 207 149.0) von FhG

Typische Formenbeschichtungstechnologien:

- Fluorpolymerbeschichtungen (wie Polytetrafluorethylen PTFE)

- Plasmapolymere Beschichtungen beschichtet mit Niederdruck-Plasmatechnik (z.B. EP 0 841 140 A2 oder Acmos/FhG DE 10 034 737 A1 oder FhG DE 10 2006 018 491 A1) oder Atmosphärendruck-Plasmatechnik (FhG DE 10 2005 059 706 A1)

- Sicon (Fraunhofer IST) (DLC-Beschichtungen)

- PlascoSAM (JE Plasma Consult GmbH) (DLC-Beschichtungen)

Zu siliziumorganischen plasmapolymeren Beschichtungen gibt es zudem eine Vielzahl weiterer Offenlegungen. Beispielsweise:

- DE 101 31 156 A1 (FhG, Artikel mit plasmapolymerer Beschichtung und Verfahren zu dessen Herstellung)

- DE 10 2009 002 780 A1 (FhG, Metallsubstrate mit kratzfester und dehnbarer Korrosionsschutzschicht und Verfahren zu deren Herstellung)

- DE 10 2007 000 611 A1 (FhG, Kratzfeste und dehnbare Korrosionsschicht für Leichtmetallsubstrate)

In EP 0 841 140 A2 werden nur allgemeine Hinweise zur Herstellung von plasmapolymeren Trennschichten gegeben ohne eine nähere Beschreibung der zu verwendenden Schichten. Es werden lediglich beispielhafte Angaben zum Wasser-Kontaktwinkel und zur Gesamt-Oberflächenenergie gemacht. Zudem gibt es keinen Hinweis darauf, wie die für einen 21 L Plasmareaktor beschriebene Beschichtungsprozedur verändert werden muss, um Kunststoffformen zu beschichten, die eine wesentlich größere Ausdehnung als die beschriebenen 1,3 x 1,2 x 22 cm haben.

In DE 10 034 737 A1 wird ein Verfahren zur Herstellung einer permanenten Entformungsschicht durch Plasmapolymerisation auf der Oberfläche eines Formteilwerkzeugs offenbart, bei dem durch zeitliche Variation der Polymerisationsbedingungen ein Gradientenschichtenaufbau in der Entformungsschicht erzeugt wird. Eine genaue Beschreibung der Zusammensetzung oder des Aufbaus der plasmapolymeren Trennschicht wird nicht gegeben. Allerdings werden beispielhafte Ausführungsvorschriften für das Beschichten von Kunststoffformen in einem 355 L Plasmareaktor gegeben. Zudem wird erwähnt, dass sich durch eine geeignete Wahl und zeitliche Variation der Parameter erreichen lässt, dass, z. B. für den Fall der Polymerisation siliziumorganischer Verbindungen, das anorganische Netzwerk (glasähnlich) direkt auf der Formoberfläche und das organische Netzwerk auf dem anorganischen Netzwerk kontinuierlich aufgebracht wird. Dadurch wird eine optimale Haftung zum Untergrund und eine optimale Permanenttrennwirkung zum Formteil hin (z. B. durch einen hohen Anteil $CH_3$- und/oder $CF_3$-Gruppen in der Oberfläche) erreicht. Die Änderung vom glasähnlichen Netzwerk in eine trennende Beschichtung wird durch die Reduktion des Sauerstoffanteiles erreicht.

DE 10 2005 059 706 A1 beschreibt ein Verfahren zum Herstellen einer plasmapolymeren Trennschicht auf einer Substratoberfläche, wobei ein Plasmapolymer auf der Substratoberfläche bei Atmosphärendruck unter zeitlich konstanten Polymerisationsbedingungen gebildet wird. Zur Trennschicht werden Angaben über die chemische Zusammensetzung gemäß XPS-Analyse gegeben, Angaben zu makroskopischen Eigenschaften wie Härte bzw. E-Modul fehlen jedoch.

In der DE 10 2006 018 491 A1 bzw. WO 2007/118905 A1 [Flexible plasmapolymere Produkte, entsprechende Artikel, Herstellverfahren und Verwendung] wird ein Artikel umfassend oder bestehend aus einem plasmapolymeren Produkt, bestehend aus Kohlenstoff, Silizium, Sauerstoff und Wasserstoff sowie gegebenenfalls üblichen Verunreinigungen, wobei im ESCA-Spektrum des plasmapolymeren Produktes, bei Kalibrierung auf den aliphatischen Anteil des C 1s Peaks bei 285,00 eV, im Vergleich mit einem trimethylsiloxy-terminierten Polydimethylsiloxan (PDMS) mit einer kinematischen Viskosität von 350 mm$^2$/s bei 25 °C und einer Dichte von 0,97 g/mL bei 25 °C, der Si 2p Peak einen Bindungsenergiewert besitzt, der um maximal 0,44 eV zu höheren oder niedrigeren Bindungsenergien verschoben ist, und der O 1s Peak einen Bindungsenergiewert besitzt, der um maximal 0,50 eV zu höheren oder niedrigeren Bindungsenergien verschoben ist, offenbart.

Erwähnt wird, dass wegen der Dehnfähigkeit dieser plasmapolymeren Beschichtung flexible Produkte, wie Folien (insbesondere dehnbare Folien) mit einer entsprechenden Antihaft- bzw. Easy-to-Clean-Oberfläche versehen werden können. Zudem wird erwähnt, dass diese plasmapolymere Beschichtung als Trennschicht oder Teil einer Trennschicht auf einer Formoberfläche verwendet werden kann.

Bei dieser plasmapolymeren Beschichtung handelt es sich um eine weiche, Beschichtung mit elastomerähnlichen mechanischen Eigenschaften. Sie zeigt gegenüber einigen Polyurethan-Schäumen eine sehr gute und dauerhafte Trennwirkung.

Üblicherweise zeigen siliziumorganische plasmapolymere Trennschichten für PUR nach dem Stand der Technik regelmäßig folgende Eigenschaften:

Nanohärte: < 0,15 GPa

E-Modul, gemessen mit einem Nanoindenter: < 1,25 GPa,

Beschichtungen die nach DE 10 2006 018 491 A1, nach DE 10 2005 059 706 A1 oder in Anlehnung an DE 10 034 737 A1 hergestellt wurden, zeigten auch gute Trenneigenschaften gegenüber einer epoxid-basierten CFK-Matrix. Beispielsweise wurde in einem RTM-Verfahren das epoxid-basierte Harz HexFlow® RTM6 von Hexel mit einem Druck von 8 bar in das geschlossene Werkzeug, welches mit einem Carbonfaser-Gewebe gefüllt war, injiziert und 90 Minuten bei 180 °C ausgehärtet. Anschließend war eine problemlose Entnahme des ausgehärteten CFK-Bauteils ohne den Einsatz von internen oder externen Trennmitteln möglich. Allerdings zeigten diese Beschichtungen eine aus wirtschaftlichen Aspekten zu geringe mechanische Beständigkeit. Spätestens nach 30 Entformungen hatten die Trenneigenschaften so stark nachgelassen, dass ein Öffnen des Werkzeugs nur noch unter hoher Kraftaufwendung möglich war. Untersuchungen zeigten, dass die Beschichtung durch die Fasern lokal zerstört war.

Zudem wurden die mechanischen Kennwerte wie die Härte bzw. den E-Modul dieser Beschichtungen mit Hilfe der Nanoindentation gemessen. Dabei zeigte sich, dass die Härte maximal 0,2 GPa und der E-Modul maximal 2,0 GPa betrug.

DE 101 31 156 A1 beschreibt einen Artikel, umfassend ein Substrat und eine flächig mit dem Substrat verbundene plasmapolymere, Sauerstoff, Kohlenstoff und Silizium umfassende Beschichtung, wobei für die Stoffmengenverhältnisse in der plasmapolymeren Beschichtung auf der von dem Substrat abgewandten Seite gilt:

1,1 : 1 < n (O): n (Si) < 2,6 : 1

0,6 : 1 < n (C) : n (Si) < 2,2 : 1;

Hier wird allerdings kein Hinweis auf eine Nutzung dieser Beschichtungen als Trennschichten zur Entformung von Kunststoffbauteilen gegeben. Ebenso werden keine Angaben zu makroskopische Eigenschaften wie die Härte bzw. den E-Modul gemacht. Tatsächlich sind diese Eigenschaften noch nicht für Trennverfahren optimiert.

In der DE 10 2007 000 611 A1 wird ein beschichtetes Leichtmetallsubstrat beschrieben: wobei die Beschichtung

- einen durch Messung mittels XPS bestimmbaren Anteil von Kohlenstoff von 5 bis 20 Atom-%, vorzugsweise 10 bis 15 Atom-%, bezogen auf die Gesamtzahl der in der Beschichtung enthaltenen Kohlenstoff-, Silizium- und Sauerstoffatome,

- einen nach ASTM D 1925 bestimmten Gelbindex (Yellow Index) von $\leq$ 3, vorzugsweise $\leq$ 2,5 und

- eine mittels Nanoindentation zu messende Härte im Bereich von 2,5 bis 6 GPa, vorzugsweise 3,1 bis 6 GPa

aufweist.

Auch hier wird kein Hinweis auf eine Nutzung dieser Beschichtungen als Trennschichten zur Entformung von Kunststoffbauteilen gegeben, die offenbarten Schichten sind hinsichtlich ihrer maßgeblichen Eigenschaftsfenster weiter verbesserungsfähig in Bezug auf den Einsatz als Formschichten.

Eine ähnliche Schicht wird in der DE 10 2009 002 780 A1 beschrieben.

DE 10 2005 014 617 A1 offenbart ein Formwerkzeug zum Gießen von Linsen aus Kunststoff, mit einem von Oberflächen begrenzten Hohlraum und mit Mitteln zum Einbringen des Kunststoffes in den Hohlraum, wobei die Oberflächen mit einer Beschichtung versehen sind, dadurch gekennzeichnet, dass die Beschichtung eine elektrische Leitfähigkeit von weniger als 1 $\Omega$cm aufweist. Als ein Beispiel für die Beschichtungen werden ternäre Verbindungen mit C, Si, O erwähnt. Einen Hinweis auf Beschichtungen mit wasserstoffhaltigen organischen Gruppen gibt es nicht.

US 2010/239783 A1 beschreibt ein Verfahren zum Herstellen einer Arbeitsform, mit einer plasmapolymeren Beschichtung. Die dort beschriebenen Schichten weisen eine Nanohärte < 0,15 GPa, und einen E-Modul, gemessen mit einem Nanoindenter, < 1,25 GPa auf.

Es hat sich gezeigt, dass gute plasmapolymere Trennschichten für PUR-Schäume nicht die am besten geeigneten plasmapolymeren Trennschichten für Faserverbundkunststoffe (FVK) sind. Stattdessen hat sich herausgestellt, dass für gute und dauerhafte Trenneigenschaften gegenüber FVK deutlich härtere Schichten als für eine Trennung gegenüber PUR-Schäumen erforderlich sind. Die chemische Zusammensetzung der oberflächennahen Bereiche der plasmapolymeren Beschichtung können dagegen wesentlich stärker variiert werden, ohne die guten Trenneigenschaften zu verlieren.

Die direkte Beschichtung von Formen mit einer Trennschicht, welche eine trennmittelfreie Fertigung ermöglicht, ist insbesondere für die Herstellung von kleineren Bauteilen mit einer Ausdehnung von maximal wenigen Metern von großem Interesse. Dabei kommt der Frage der Dauerhaftigkeit der Trennwirkung und damit einer erhöhten mechanischen Stabilität eine herausragende Stellung zu, denn nur eine möglichst "permanente" Trennwirkung ermöglicht den gewünschten wirtschaftlichen Vorteil. Dies gilt insbesondere dann, wenn die Verfügbarkeit der Form - beispielsweise, da sie ausgebaut und zu einem Niederdruck- Plasmareaktor transportiert werden muss - wegen des Beschichtens deutlich eingeschränkt wird.

Im Unterschied zur Herstellung von PUR-Bauteilen werden bei der Herstellung von Faserverbundbauteilen, insbesondere von CFK- und GFK-Bauteilen, beispielsweise Epoxidharze eingesetzt, welche häufig bei hohen Temperaturen (120° - 190°C) zu einem harten und starren Körper ausgehärtet werden. Dies führt dazu, dass das Reaktivharz im Bereich der Interphase an der Grenzfläche zur Trennschicht, im Gegensatz zur PUR-Herstellung sehr gut vernetzt ist und Teil des Festkörpers geworden ist. Dadurch wird ein Bruch in der Interphase unwahrscheinlicher - die Anforderungen an die Trennleistung der Trennschicht sinken geringfügig.

Dafür treten jedoch Anforderungen an andere Eigenschaften in den Vordergrund. Hierzu gehört insbesondere die Härte und Widerstandsfähigkeit der Trennschicht und sowohl ihre Fähigkeit geringe Reibung als auch ein geringes Losbrechmoment zum entstandenen Bauteil aufzubauen. Diese Eigenschaften sind für den Trennvorgang selbst und auch für die Dauerhaftigkeit der Trennwirkung notwendig, andernfalls ist mit flächigen und/oder lokalen Defekten (und einer geringer werdenden Trennleistung) zu rechnen. Ferner sind sie wichtig für einen einfachen und effektiven Entformungsprozess.

In diesem Zusammenhang sei darauf hingewiesen, dass eine gute Trennwirkung zwar die Grundvoraussetzung für einen erfolgreichen Entformungsprozess ist, jedoch nicht die hinreichende Bedingung. Ein Entformungsprozess für eine trennmittelfreie Entformung erfordert zwingend die Möglichkeit, dass Form bzw. beschichtete Form und Werkstück im Sinne einer Schälbewegung voneinander getrennt werden. Die heute vielfach benutzte Art und Weise einen Werkzeugdeckel senkrecht abzuheben ist für eine dauerhaft wirkende Trennschicht nicht entformungsgerecht.

Eine hohe mechanische Stabilität der Trennschicht ist z.B. insbesondere dann gefragt, wenn harte trockene Fasermaterialien verarbeitet werden und hierfür ein geschlossenes Werkzeug verwendet wird, welches die Fasern zusammenpresst. In einer solchen Vorrichtung werden die Fasern, insbesondere Ondulationen lokal mit hoher Kraft auf die beschichtete Werkzeugoberfläche gedrückt. Es entstehen kleine Defektstellen in der plasmapolymeren Trennschicht nach DE 10034737, welche langsam räumlich wachsen und die Trennleistung herabsetzen.

In diesem Zusammenhang haben eigene Untersuchungen gezeigt, dass die oben beschriebene Trennschicht, welche für höchste Trennleistungen gegenüber PUR optimiert wurde, zu weich ist. Sie weist eine Nanohärte im Bereich von 0,005 - 0,015 GPa und einen E-Modul im Bereich von 0,7 bis 1,25 GPa auf.

Entsprechend dem Schichtaufbau in DE 10034737 (Beispiel 3) wird dem Fachmann nahegelegt die plasmapolymere Trennschicht dadurch härter zu gestalten, dass er den Sauerstoffanteil während des Beschichtungsvorganges erhöht und somit von den vorgeschlagenen Gasmischungsverhältnissen abweicht. Leider wird hierdurch gleichzeitig die Oberflächenenergie und insbesondere der polare Anteil der Oberflächenenergie der Trennschicht erhöht, die Trenneigenschaften lassen rasch deutlich nach.

Zudem hat sich in der Praxis gezeigt, dass gewisse Bauteile, wie z.B. ein zylinderförmiger Ring, nur mit einer Enformungsschrägen zu entformen sind. Das Bauteil schrumpft durch die Vernetzungsreaktionen innerhalb der Matrix und das Abkühlen nach dem Öffnen der Form auf den inneren Kern auf. Zur Ablösung ist dann sowohl eine Entformungsschräge, als auch eine widerstandsfähige und reibungsfreundliche Trennschichtoberfläche notwendig. Insbesondere ein niedriges Losbrechmoment erleichtert den Trennvorgang ebenso wie ein hohes E-Modul der Beschichtung.

Demzufolge sind plasmapolymere Trennschichten wünschenswert, die einerseits deutlich härter sind, als Schichten nach dem Stand der Technik, jedoch gleichzeitig sehr niedrige Oberflächenenergien mit geringem polaren Anteil, und/oder auch einen niedrigen Reibwert und einen niedriges Losbrechmoment aufweisen.

Den Schichten aus dem Stand der Technik ist gemein, dass sie verbesserungswürdig sind für den Einsatz in den Trennverfahren in der Kunststoffverarbeitung, insbesondere in den Trennverfahren gegenüber Faserverbundwerkstoffen. Dabei sind sowohl die Eigenschaften Trennbarkeit (Adhäsionsbruch zwischen Schicht und Bauteil) und Haltbarkeit in den Verarbeitungsverfahren von Bedeutung. Dabei lässt sich eine gute Haltbarkeit in vielen Anwendungsbereichen nur durch ein geeignetes Eigenschaftsprofil der Kombination von Härte, Flexibilität und Trennleistung erreichen.

Ein zweiter Aspekt der vorliegenden Erfindung ist Korrosionsschutz. Korrosionsschutz ist eine wichtige technische Aufgabe, denn Korrosion vernichtet Vermögen und sorgt für Maschinenstillstand. Daher existieren die unterschiedlichsten Verfahren Oberflächen korrosionshindernd auszurüsten. Hierzu zählen passive Korrosionsschutzverfahren durch Lackieren oder die Anwendung galvanischer Verfahren. Oberflächen werden beispielsweise eloxiert, verzinkt, brüniert, chromatiert oder phosphatiert. Neben passiven Korrosionsschutzverfahren existieren auch einige aktive Verfahren, bei denen Beschichtungen korrosionsinhibierende Stoffe abgeben.

Aufgrund besonderer Anforderungen an die Korrosionsschutzschicht, wie z.B. einem guten Wärmedurchgang bei Wärmeübertragern (umgangssprachlich Wärmetauscher genannt) oder eine hohe Präzision bei der Abbildung der zu schützenden Oberflächenstruktur (Kanten, Prägungen etc.) gibt es einen Bedarf an Dünnschicht-Korrosionsschutzschichten, welche die zu schützende Oberfläche möglichst wenig verändern, keine Schwermetalle abgeben und das Substrat beim Beschichten nicht übermäßig mit Wärme belasten. Dieser Bedarf kann z.B. mit plasmapolymeren Korrosionsschutzschichten gedeckt werden, welche typischerweise in einem Schichtdickenbereich von 10 bis 5000 nm aufgetragen werden. Zudem eignet sich das plasmapolymere Beschichtungsverfahren grundsätzlich, um in enge Strukturen, wie sie z.B. häufig bei einem Wärmeübertrager gegeben sind, einzudringen oder auch die Passungsgenauigkeit des Bauteils zu erhalten.

Um plasmapolymere Korrosionsschutzschichten wirtschaftlich günstig auftragen zu können ist entweder eine sehr hohe Schichtabscheiderate und/oder eine Möglichkeit wünschenswert gleichzeitig viele Bauteile bzw. eine große Bauteiloberfläche beschichten zu können. Weiterhin wäre es von großem Vorteil, wenn das zu beschichtende Substrat nicht einer besonderen Vorbehandlung unterzogen werden müsste.

Die DE 19748240 A1 (FhG) beschreibt ein Verfahren zum Herstellen eines plasmapolymeren Korrosionsschutzes, bei dem das Substrat vor der Beschichtung zunächst geglättet wird und ein erster Prozessschritt mit reduzierenden Plasmabedingungen verwendet wird. Über die Zusammensetzung der Beschichtung selbst wird lediglich angegeben, dass es sich um eine Beschichtung hergestellt aus Kohlenwasserstoffen bzw. siliziumorganischen Stoffen handelt. Während der Beschichtung wird zusätzlich Sauerstoff, Stickstoff oder ein Edelgas in das Plasma eingespeist. Es finden sich weder Angaben zur Zusammensetzung noch zu weiteren besonderen Eigenschaften der Beschichtung.

Allerdings ist angegeben, dass die Beschichtung als Korrosionsschutzschicht für Wärmeübertrager in Brennwertkesseln geeignet ist.

Die DE 10200700611 A1 (FhG) zielt auf eine kratzfeste und dehnbare Korrosionsschutzschicht für Leichtmetalle ab. Für diese Beschichtung werden Nanohärtewerte im Bereich von 2,5 bis 6 GPa angegeben. Zudem darf die Beschichtung keine Gelbfärbung aufweisen und nur über einen Kohlenstoffanteil von 5 - 20% mittels XPS verfügen. Dadurch wird die gewünschte Härte und Kratzfestigkeit sichergestellt.

Für die Beschichtung wird das Verfahren so geführt, dass sich ein Self-Bias zwischen 50 und 1000 V ausbildet. Dies hat den Vorteil, dass seinerseits eine hohe Abscheiderate erreicht werden kann, denn für kratzfeste Schichten sind Schichtdicken ab 2 - 4 $\mu$m vorteilhaft. Weiterhin wachsen die Schichten unter ständigem Ionenbeschuss auf, dadurch erfolgen eine ständige Umlagerung und ein ständiger Energieeintrag, so dass die Schichten sich entspannen können. Hierdurch wird die besondere Dehnfähigkeit der Schichten sichergestellt.

Für die Beschichtung werden Gasverhältnisse von HMDSO zu $O_2$ zwischen 1 : 1 und 1 : 6 als vorteilhaft angegeben. Allerdings ist eine Aufskalierung nur sehr schwer durchzuführen, denn die Ausbildung des Self-Bias ist abhängig von der zu beschichtenden Fläche im Verhältnis zur Masseoberfläche der Niederdruckplasmakammer. Dadurch wird auch die Wirtschaftlichkeit eingeschränkt. Zudem ist davon auszugehen, dass die Beschichtung in engen Spalten nur noch sehr eingeschränkt durchführbar ist, da sich dort das elektrische Feld abschwächt, stark verzerrt und ggf. nicht mehr vorhanden ist. Hierdurch wird nicht nur die Abscheiderate negativ beeinflusst, sondern auch die Schichtqualität.

Die DE 102009002780 A1 (FhG) zielt auf eine kratzfeste und dehnbare Korrosionsschutzschicht für Nichtleichtmetalloberflächen ab. Hier werden Nanohärten im Bereich von 2,5 bis 10 GPa und Dehnungen bis Mikroriss > 1,5% beansprucht.

Weitere plasmapolymere Korrosionsschutzschichten verwenden Mehrlagenaufbauten. Zum Beispiel JP 63235463 A stellt eine plasmapolymere Korrosionsschutzschicht auf metallischen Substraten mit Hilfe eines Monomers mit polarer Gruppe (z.B. Pentafluoracetophenon) dar und fügt eine zweite Beschichtungslage hergestellt mit einem hydrophoben fluorhaltigen Monomer (z.B. Hexafluorbenzol) hinzu.

Die JP 2154993 A verbessert die Korrosionsbeständigkeit ebenfalls durch einen zweilagigen Schichtaufbau. Hier besteht die innere Lage aus einem hydrophoben organischen Film bedeckt mit einem hydrophilen plasmapolymeren Deckfilm. Letzterer wird z.B. aus organischen, aminischen Produkten (z.B. n-Butylamin, Isopropylamin) hergestellt.

Andere Lösungsansätze verfolgen die Oxidation der Metalloberfläche mit Hilfe eines Plasmaprozesses (WO 02059391 A1). Die so entstandene Oberfläche kann mit einem beliebigen plasmapolymeren Film versehen werden. Neben 2-lagigen Aufbauten werden noch Vielfachlagen vorgeschlagen (WO 02059051 A2).

Zu den Mehrschichtaufbauten gehört auch die WO 9701656 A1, welche jedoch eine stark hydrophile Deckschicht vorsieht, um die Bildung eines Wasserfilms zu unterstützen.

Weiterhin ist bekannt, dass starke Laugen nicht in Glasgefäßen aufbewahrt werden sollen, da diese die meisten Gläser angreifen. Stattdessen werden Behälter aus Kunststoffen bevorzugt, z.B. aus Polyethylen. Demzufolge erscheint es nicht sinnvoll $SiO_2$-ähnliche Schichten als Korrosionsschutzschichten für starke Laugen zu verwenden.

Es hat sich in Untersuchungen gezeigt, dass nicht nur eine gute Oberflächenabdeckung des Substrates mit einer plasmapolymeren Korrosionsschutzschicht notwendig ist, um eine gute Korrosionsschutzwirkung zu erhalten, wie es durch die Glättung des Substrates in DE 19748240 A1 oder durch eine höhere Schichtdicke im Bereich von 2 - 5 $\mu$m wie in DE 10 2007 00 611 A1 und DE 10 2009 002 780 A1 nahe gelegt wird, sondern auch eine optimale Stabilität der Beschichtung gegenüber dem auf die Oberfläche wirkenden Agens, z.B. starke Säuren oder Laugen. Dies kann z.B. durch $SiO_2$-ähnliche Beschichtungen in Bezug auf starke Säuren erreicht werden. Derartige Schichten sind jedoch sehr eigenspannungsreich, so dass diese schlecht haften und zur Rissbildung neigen, insbesondere wenn sie dicker als 50 nm sind. Damit ist die erfolgreiche Beschichtung von metallischen Substraten mit technischer Oberflächenrauigkeit nahezu ausgeschlossen. Zudem ist die Abscheiderate für solche Schichten sehr schlecht, da mit einem hohen Sauerstoffüberschuss gearbeitet werden muss. Schließlich sind diese Schichten für starke Laugen nicht einsetzbar.

Für viele Anwendungen ist eine Verbesserung der Korrosionsschutzeigenschaften gegenüber dem Stand der Technik wünschenswert. Dies betrifft insbesondere die Beständigkeit gegen starke Laugen und Säuren kombiniert mit einer verhältnismäßig hohen Härte und einer guten Aufbringfähigkeit des Korrosionsschutzes. Insbesondere sollte die Korrosionsschutzschicht auch in engen Spalten abscheidbar sein und/oder keine gesonderten Glättungsverfahren der zu schützenden Oberflächen voraussetzen. Ferner ist es wünschenswert Korrosionsschutz großflächig, zügig und kostengünstig auftragen zu können.

Entsprechend dem Vorgesagten war es Aufgabe der vorliegenden Erfindung, Oberflächen zur Verfügung zu stellen, die für eine Vielzahl von technischen Anforderungen verbesserte Eigenschaften bereitstellen. Insbesondere war es gemäß dem ersten Aspekt der Erfindung bevorzugt, dass die zur Verfügung gestellten Oberflächen gute Trenneigenschaften, insbesondere für Trennverfahren der Kunststoffverarbeitung und hier insbesondere für die Trennung in der Kunststoffverarbeitung von Faserverbundwerkstoffen besitzen.

Zudem war es gemäß dem zweiten Aspekt der Erfindung eine bevorzugte Aufgabe ein Mittel für verbesserten Korrosionsschutz für viele Anwendungsbereiche anzugeben. Insbesondere war es wünschenswert, dass sich der erfindungsgemäße Korrosionsschutz effektiv, großflächig und/oder kostengünstig auch auf Oberflächen aufbringen lässt, die eine starke Strukturierung wie z.B. Spalten und tiefe Eingriffe besitzen. Vornehmlich sollte der Korrosionsschutz über eine gute Wirksamkeit, insbesondere auf Aluminiumlegierungsoberflächen, bevorzugt auch ohne eine vorherige Oberflächenglättung des Substrates, verfügen. Von besonderer Bedeutung war dabei, dass der erfindungsgemäße Korrosionsschutz über eine gute mechanische Widerstandsfähigkeit verfügt, da in vielen Anwendungsbereichen die zu schützenden Oberflächen mechanischen Belastungen ausgesetzt sind.

Diese Aufgabe wird gelöst durch einen plasmapolymeren Festkörper insbesondere plasmapolymere Schicht, wobei die Untergrenze des E-Moduls der Beschichtung durch folgende Funktion (1) bestimmt ist:

$$E = 25 - 31,5 * x + 13,5 * x^2 - 1,85 * x^3 \qquad (1)$$

mit

x = C/O Verhältnis ermittelt mittels XPS

E = E-Modul [GPa]

für E ≥ 1,25 GPa und

x ≥ 0,5 und ≤ 2,0

wobei auf der Oberfläche der Schicht gemessen mittel XPS für das Maximum des Si 2p -Peaks gilt:

für E-Modul < 10 GPa: 102,5 - 102,8 eV
für E-Modul 10-20 GPa: 102,7 - 103,1 eV und bevorzugt für
für E-Modul > 20 GPa: > 103,0 eV.

Überraschenderweise hat sich dabei herausgestellt, dass sich die erfindungsgemäßen plasmapolymeren Festkörper, insbesondere die plasmapolymeren Schichten sowohl für den ersten Aspekt der Erfindung (Verbesserung der Trenneigenschaften) als auch für den zweiten Aspekt der Erfindung (Korrosionsschutz) sehr gut eignen.

Erfindungsgemäße Festkörper bzw. die erfindungsgemäßen Schichten werden weiter unten noch genauer charakterisiert.

Für den ersten Aspekt der Erfindung wird die obige Aufgabe besonders gut gelöst, durch einen plasmapolymeren Festkörper, insbesondere eine plasmapolymere Schicht, wobei die Untergrenze des E-Moduls der Beschichtung durch folgende Funktion (1) bestimmt ist:

$$E = 25 - 31,5 * x + 13,5 * x^2 - 1,85 * x^3 \qquad (1)$$

mit

x = C/O Verhältnis ermittelt mittels XPS
E = E-Modul [GPa]
für E ≥ 1,5 GPa bevorzugt ≥ 1,75 GPa, weiter bevorzugt ≥ 2,5 GPa, besonders bevorzugt ≥ 3 GPa und
x ≥ 0,5 und ≤ 2,0

wobei auf der Oberfläche der Schicht gemessen mittel XPS für das Maximum des Si 2p -Peaks gilt:

für E-Modul < 10 GPa: 102,5 - 102,8 eV
für E-Modul 10-20 GPa: 102,7 - 103,1 eV und bevorzugt für
für E-Modul > 20 GPa: > 103,0 eV

Bevorzugt gilt insbesondere für den ersten Aspekt der Erfindung unter den vorgenannten Randbedingungen für die Untergrenze des E-Moduls:

$$E = 32,5 - 38 * x + 13,6 * x^2 - 1,17 * x^3 \qquad (1a)$$

und besonders bevorzugt

$$E = 39,4 - 42,3 * x + 12,3 * x^2 - 0,33 * x^3 \qquad (1b)$$

Bevorzugt insbesondere für den ersten Aspekt der Erfindung liegt auf der Oberfläche der erfindungsgemäßen Schicht gemessen das Maximum des Si 2p-Peaks bei einem E-Modul von 10-20 GPa bei > 102,8 bis < 103,0 eV.

Für den zweiten Aspekt der Erfindung (Korrosionsschutz) wird die oben beschriebene Aufgabe bevorzugt gelöst durch einen plasmapolymeren Festkörper, insbesondere eine plasmapolymere Schicht, wobei die Untergrenze des E-Moduls der Beschichtung durch folgende Funktion (1) bestimmt ist:

$$E = 25 - 31,5 * x + 13,5 * x^2 - 1,85 * x^3 \qquad (1)$$

mit

x = C/O Verhältnis ermittelt mittels XPS
E = E-Modul [GPa]
für E = 1,25 - 10 GPa bevorzugt 1,5 - 9 GPa, weiter bevorzugt 2,0 - 8 GPa, besonders bevorzugt 2,5 - 7,5 GPa und
$x \geq 0,5$ und $\leq 2,0$

wobei auf der Oberfläche der Schicht gemessen mittels XPS das Maximum des Si 2p -Peaks bei 102,5 - 102,8 eV liegt.

Bevorzugt gilt für den zweiten Aspekt der Erfindung unter den vorgenannten Randbedingungen für die Untergrenze des E-Moduls:

$$E = 25,75 - 31,5 * x + 13,5 * x^2 - 1,85 * x^3 \qquad (1a)$$

und besonders bevorzugt

$$E = 26,2 - 31,5 * x + 13,5 * x^2 - 2 * x^3 \qquad (1b).$$

Plasmapolymere unterscheiden sich von Polymeren dadurch, dass bei ihrer Herstellung eine Fragmentierung von Precursoren erfolgt. Dementsprechend zeigen Plasmapolymere im Unterschied zu klassischen Polymeren keine regelmäßigen repetitiven Untereinheiten, auch wenn - je nach Herstellungsprozess - eine Nahordnung nicht ausgeschlossen werden kann.

Der E-Modul im Sinne der vorliegenden Erfindung wird mittels des im Messbeispiel 1 beschriebenen Verfahrens bestimmt.

Das C/O-Verhältnis wird mittels XPS (x-ray photoelectron spectroscopy) im Zweifelsfall gemäß dem Messbeispiel 2 ermittelt. Das Gleiche gilt auch für Verschiebung des Maximums des Si 2p Peaks.

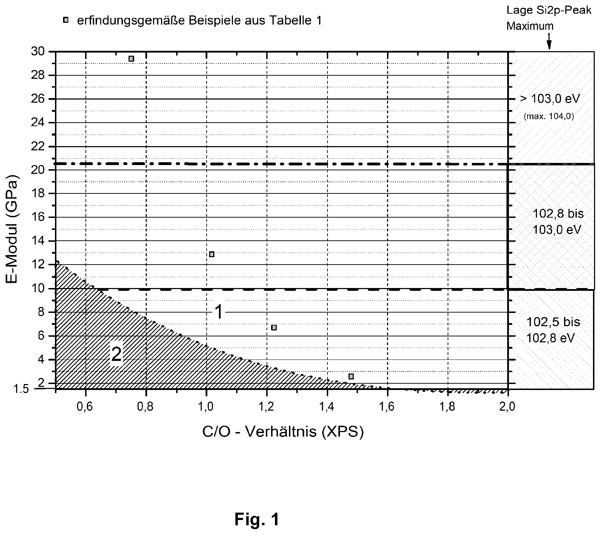

Der Bereich des bevorzugten erfindungsgemäßen Merkmalfensters für den ersten Aspekt der Erfindung ist in Figur 1 als nicht-schraffierter Bereich (1) dargestellt. Der schraffierte Bereich (2) stellt für den ersten Aspekt der Erfindung nicht bevorzugte oder sogar nicht erfindungsgemäße Merkmalskombinationen dar.

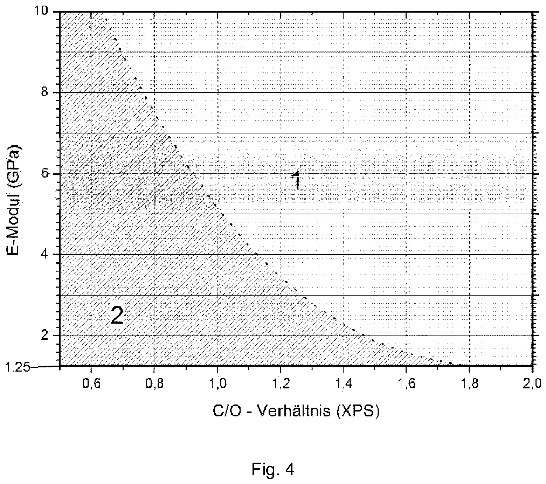

Der Bereich des bevorzugten erfindungsgemäßen Merkmalfensters für den zweiten Aspekt der Erfindung ist in Figur 4 als nicht-schraffierter Bereich (1) dargestellt. Der schraffierte Bereich (2) stellt für den zweiten Aspekt der Erfindung nicht bevorzugte oder sogar nicht erfindungsgemäße Merkmalkombinationen dar.

Die Bedeutung der Merkmale des erfindungsgemäßen Gegenstandes erschließt sich nur für den Fachmann unmittelbar, deshalb sollen hier noch weitere Erläuterungen gegeben werden:
Überraschend ist, dass es bei einem gegebenen C/O-Verhältnis möglich ist, Schichten mit einem höheren E-Modul darzustellen, als es bislang im Stand der Technik möglich war, wenn man zusätzlich noch die Lage des Si 2p-Peaks berücksichtigt. Es ist wünschenswert, bei einem gegebenen C/O-Verhältnis einen hohen E-Modul zu erzeugen, da das C/O-Verhältnis das Oberflächenverhalten hinsichtlich der Oberflächenenergie beeinflusst. So führt beispielsweise ein hohes C/O-Verhältnis tendenziell zu einem geringen polaren Anteil der Oberflächenenergie, was zum Beispiel die Trennneigenschaften der Schicht und die Wiederstandsfähigkeit gegen Laugen verbessert, führt aber gleichzeitig zu geringen E-Moduli, wie in den Figuren 1 und 4 dargestellt. Ein verhältnismäßig hoher E-Modul ist aber insbesondere für den zweiten Aspekt der Erfindung wünschenswert, da die mechanische Belastbarkeit umso höher ist, je höher der E-Modul ist.

Die Lage des Si 2p-Peaks (Maximum) gibt wiederum Auskunft über die Nah-Bindungsverhältnisse am Si-Atom innerhalb der plasmapolymeren Schicht, was Hinweise über die in der Schicht erzeugten Härteverhältnisse beinhaltet. Niedrige Si 2p-Peaklagen weisen auf eine sauerstoffarme Si-Umgebung hin. Steigt sie an, so wird das SiO-Netzwerk immer stärker ausgebildet bis hin zu einem $SiO_2$-ähnlichen Netzwerk. Im Sinne der Erfindung ist es, wenn der Plasmapolymerisationsprozess so geführt wird, dass einerseits die Bildung des SiO-Netzwerkes zur Härtesteigerung gefördert wird und andererseits die kohlenstoffhaltigen Gruppen möglichst wenig plasmachemisch verbrannt bzw. oxidiert werden. Letzteres manifestiert sich in einem hohen C/O-Verhältnis und einer niedrigen Oberflächenenergie.

Wie bereits angedeutet, wurde von Fachleuten bislang regelmäßig versucht, einen erhöhten E-Modul bzw. eine erhöhte Härte durch eine Erhöhung des Sauerstoffanteils während der Schichtbildung zu erzeugen. Dies hatte zwar die gewünschten Folgen für den E-Modul und die Härte, aber die Schichten wurden gleichzeitig nachteilig verändert, da durch die Sauerstoffzugabe gleichzeitig Kohlenwasserstoff-Gruppen abgebaut wurden und das C/O-Verhältnis sank. Letztlich stieg der polare Anteil der Oberflächenenergie deutlich an.

Überraschenderweise hat es sich im Rahmen der Erfindung nun herausgestellt, dass es möglich ist, bei Einkopplung von hohen Leistungen in den Abscheidungsprozess während der Abscheidung der plasmapolymeren Schichten bei gegebenen C/O-Verhältnissen deutlich verbesserte E-Moduli zu erzeugen, wobei es zudem noch möglich ist, die gewünschten Merkmalfenster der Si 2p-Peaks zu erreichen. Gleichzeitig ist es möglich, den polaren Anteil der Oberflächenenergie klein zu halten. Für diesen Ansatz gab es im Stand der Technik bislang keine Hinweise und dementsprechend war es faktisch nicht möglich, die erfindungsgemäßen Schichten gemäß dem oben beschriebenen Merkmalfenster zu erzeugen.

Mit anderen Worten zeigt das Merkmalsprofil der vorliegenden Erfindung, dass die Schichteigenschaften keineswegs ausschließlich auf der stofflichen Zusammensetzung beruhen, sondern auch wesentlich durch die Art und Weise der Schichtvernetzung (und damit durch die Plasmapolymerisationsbedingungen) bedingt werden. Allerdings zeigte sich auch, dass das C/O-Verhältnis bei plasmapolymeren Schichten einen wesentlichen Einfluss auf die Trenneigenschaften ausübt. Außerdem zeigte sich, dass das C/O-Verhältnis und parallel hierzu der polare Anteil der Oberflächenenergie bei diesen Schichten einen wesentlichen Einfluss auf die Oberflächeneigenschaften (Hydrophilie, Hydrophobizität), aber auch auf die Volumeneigenschaften im Hinblick auf die Stabilität gegenüber starken Laugen und Säuren ausübt.

Wie bereits angedeutet, war dem Fachmann aus dem Stand der Technik bekannt, dass der E-Modul und die Härte von plasmapolymeren Schichten durch das Verhältnis von Sauerstoff zu Kohlenstoff in der Schicht bzw. durch das Verhältnis von Sauerstoff zu siliziumorganischem Precursor im Plasmaprozess beeinflusst werden kann. Die Erhöhung des Sauerstoffgehaltes führt aber zu einer hohen Oberflächenenergie mit einem vergleichsweise hohen polaren Anteil der Oberflächenenergie. Damit wurden Oberflächeneigenschaften, wie z.B. die Trenneigenschaften oder die Widerstandseigenschaften gegen korrosive Flüssigkeiten, insbesondere Laugen, deutlich verschlechtert.

Um erfindungsgemäße Beschichtungen (auch bevorzugte und besonders bevorzugte) herzustellen, werden dementsprechend eine oder mehrere der nachfolgenden Maßnahmen empfohlen:

- Verwendung einer Plasmapolymerisationsanlage mit HF-Anregung (z.B. 13,56 MHz) und einer Leckrate < 0,3 mbar L/s, bevorzugt < 0,1 mbar L / s.

- Auslegung der Anlage über das Verhältnis Elektrodenfläche und Massefläche, dass sich unter den später zu verwendenden Einstellungen ein Self-Bias < 10 V, vorzugsweise < 1 V ergibt und Nebenplasmen vermieden werden.

- Verwendung von siliziumorganischen Precursoren zusammen mit sauerstoffhaltigen Gasen; vorzugsweise Hexamethyldisiloxan (HMDSO) und $O_2$; besonders bevorzugt HMDSO in ähnlichen Mengen wie $O_2$, z.B. im Verhältnis 2 : 1 bis 1 : 1 (insbesondere erster Aspekt der Erfindung) oder

- Verwendung von siliziumorganischen Precursoren zusammen mit sauerstoffhaltigen Gasen; vorzugsweise Hexamethyldisiloxan (HMDSO) und $O_2$; besonders bevorzugt HMDSO im Überschuss gegenüber $O_2$, z.B. im Verhältnis 2 : 1 (insbesondere zweiter Aspekt der Erfindung).

- Elektrische Kontaktierung der zu beschichtenden metallischen Bauteile mit der HF-Elektrode derart, dass die zu beschichtende Seite im Kontakt mit dem Plasmapolymerisationsprozess kommen kann.

- Sofern nicht leitende Proben (z.B. Wafer, Glasobjektträger) verwendet werden, sollten diese vorzugsweise ein Dicke von 2 mm nicht überschreiten, damit sich das Plasma nahezu ungehindert oberhalb der Probe ausbilden kann. Dies gilt insbesondere für den ersten Aspekt der Erfindung.

- Erstellung einer Leistungsreihe, z.B. zwischen 500 und 1500 W und Ermittlung der Schichteigenschaften, insbesondere des E-Moduls, und ggf. der Nanohärte, als der Oberflächenenergie und/oder deren polaren Anteils. Dabei ist zu berücksichtigen, dass der E-Modul und die Oberflächenenergie sich mit steigender Leistung erhöhen.

- Erhöhung/Erniedrigung der Gesamtgasmenge (bei gleichbleibendem Mischungsverhältnis) zur Erniedrigung/Erhöhung des E-Moduls und ggf. der Nanohärte der Beschichtung. Dabei ist zu berücksichtigen, dass sich der E-Modul mit abnehmender Gesamtgasmenge erhöht.

Vielfach in der Literatur verwendete Kenngrößen, wie z.B. der Yasuda - Parameter, der Becker - Parameter oder der Reaktor - Parameter sollten nicht zur makroskopischen Beschreibung des Plasmapolymerisationsprozesses herangezogen werden, da sie nicht alle Randbedingungen des Beschichtungsprozesses berücksichtigen. In Vissing [Vissing, K.: Aufskalierung plasmapolymerer Beschichtungsverfahren, Dissertation, Culliver, (2008) ISBN 978-3-86727-548-4] wurde am Beispiel von Trennschichten gezeigt, dass eine neue Kenngröße V die Situation der Schichtherstellung in unterschiedlichen Reaktoren besser abbilden kann, denn sie berücksichtigt die Anlagengröße, den Massefluss und die eingesetzte Plasmaleistung. Die dort dargestellten Anlagen entsprechen dem Stand der Technik.

Angepasst auf die hier erfindungsgemäß verwendete Elektrodenkonfiguration wird V statt mit der Reaktorlänge LA mit der wirksamen Elektrodenfläche (Elektrodenfläche über welche Plasma gebildet werden kann) berechnet. Die hieraus resultierende Kenngröße V* kann zusätzlich verwendet werden, um die erfindungsgemäße Beschichtung zu beschreiben und dem Fachmann Hinweise geben. Aus der angepassten Kenngröße V* kann bei gegebenem Gasflussverhältnis bei einer beliebig großen Anlage die notwendige Größenordnung der eingebrachten Leistung für die eingebrachte Gesamtgasmenge abgeleitet werden. Bevorzugte Werte für V* für die Herstellung des erfindungsgemäßen Festkörpers bzw. Schichten (im erfindungsgemäßen Verfahren, siehe unten) sind:

$$1{,}5 * 10^9 \text{ bis } 5 * 10^9 \text{ J s / g cm}$$

Allerdings kann auch die neue Kenngröße nicht direkt die Vernetzungssituation beschreiben, die sich aus der Gaszusammensetzung und dem Fragmentierungsgrad ergibt.

Erstaunlicherweise lassen sich, wie bereits angedeutet, unter den oben angegebenen Randbedingungen auch ohne zusätzliche Zugabe von Sauerstoff Trennschichten und/oder Korrosionsschutzschichten mit höherem E-Modul und ggf. gleichzeitig verringerter Oberflächenenergie als nach dem Stand der Technik nahegelegt erzeugen.

Entsprechend dem Vorgesagten ist es bevorzugt, dass die erfindungsgemäßen plasmapolymeren Schichten zu ≥ 90 %, bevorzugt ≥ 95 %, besonders bevorzugt ≥ 98 % und ganz besonders bevorzugt vollständig aus den Elementen C, O, Si, H und optional Fluor bestehen. Für viele Fälle ist es bevorzugt, wenn auch kein Fluor in den erfindungsgemäßen Schichten enthalten ist. Grundsätzlich lassen sich erfindungsgemäße Schichten durch den Einsatz von siliziumorganischen Precursoren in Kombination mit Sauerstoff besonders effektiv herstellen. Hierzu sei beispielsweise auch auf die oben angeführten, Stand der Technik bildenden Dokumente verwiesen.

Da es möglich ist, mit den neuen Erkenntnissen, auf denen die vorliegende Erfindung beruht, bei einem gegebenen C/O-Verhältnis höhere E-Moduli zu erzeugen als bislang im Stand der Technik beschrieben, ist es auch möglich, bei gegebenen E-Moduli besonders günstige Oberflächenenergieverhältnisse zu erzeugen. Auch das war aus dem Stand der Technik nicht vorhersagbar.

Entsprechend ist ein bevorzugter plasmapolymerer Festkörper bzw. eine bevorzugte plasmapolymere Schicht im Sinne der Erfindung ein solcher bzw. eine solche, wobei der maximale polare Anteil der Oberflächenenergie der Oberfläche durch folgende Funktionen (2) oder (2a) bestimmt ist:

$$\sigma(p) = 0{,}28 * E + 0{,}106 \qquad (2)$$

oder

$$\sigma(p) = 1{,}2 \qquad (2a)$$

je nachdem welcher Wert der Funktionen (2) und (2a) der größere ist,
mit

$\sigma(p)$ = polarer Anteil der Oberflächenenergie [mN/m]
E = E-Modul [GPa]
für E = 1,5 - 30 GPa bevorzugt 1,75 - 28 GPa, weiter bevorzugt 2,5 - 25 GPa, und besonders bevorzugt 3 - 25 GPa (diese E-Werte gelten bevorzugt für den ersten Aspekt der Erfindung) bzw.

für E = 1,25 - 10 GPa bevorzugt 1,5 - 9 GPa, weiter bevorzugt 2,0 - 8 GPa, und besonders bevorzugt 2,5 - 7,5 GPa (diese E-Werte gelten bevorzugt für den zweiten Aspekt der Erfindung)

und/oder

die Oberflächenenergie der Oberfläche hinsichtlich ihrer Obergrenze durch folgende Funktion (3) bestimmt ist:

$$\sigma = 0,9 \, {}^*E + 21,7 \qquad (3)$$

und die Oberflächenenergie der Oberfläche hinsichtlich ihrer Untergrenze durch folgende Funktion (4) bestimmt ist:

$$\sigma = 0,25 \, {}^*E + 22,25 \qquad (4)$$

mit

$\sigma$ = Oberflächenenergie [mN/m]
E = E-Modul [GPa].

Dabei gelten die bevorzugten E-Modulbereiche allgemein für diese Erfindung, also ohne zwingend an die Oberflächenenergie gebunden zu sein. Bevorzugt gilt Funktion (2a) unabhängig von den Werten der Funktion (2) als Obergrenze des maximalen (polaren) Anteils der Oberflächenenergie.
Die Oberflächenenergie und der polare Anteil der Oberflächenenergie wird gemäß dem Messbeispiel 3 bestimmt.

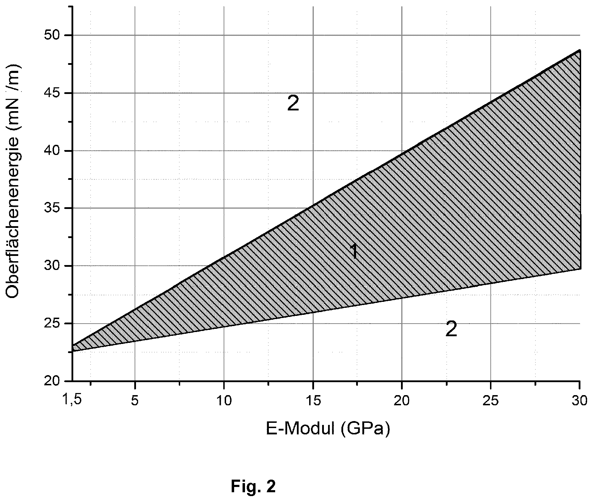

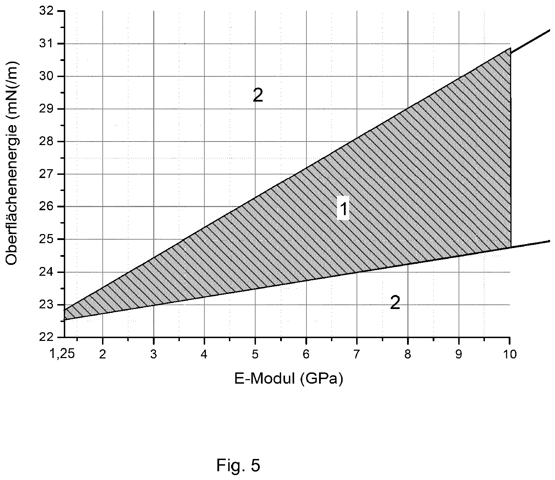

Figur 2 stellt als schraffierte Fläche (1) das durch die Gleichung (3) und (4) bedingte für den ersten Aspekt der Erfindung bevorzugte Merkmalfenster E-Modul gegen Oberflächenenergie dar. Figur 5 stellt das gleiche für den zweiten Aspekt der Erfindung dar. Die Bereiche (2) stellen dabei jeweils nicht bevorzugte bzw. nicht erfindungsgemäße Merkmalskombinationen dar.

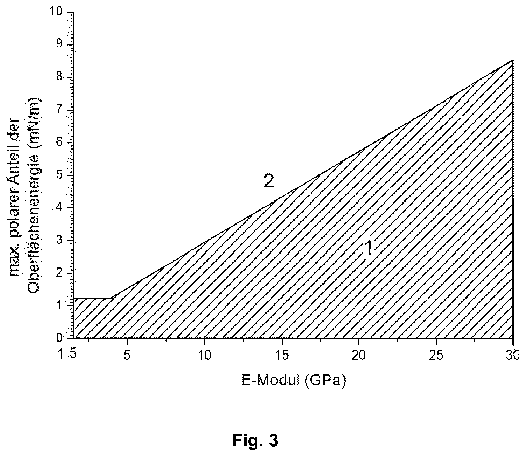

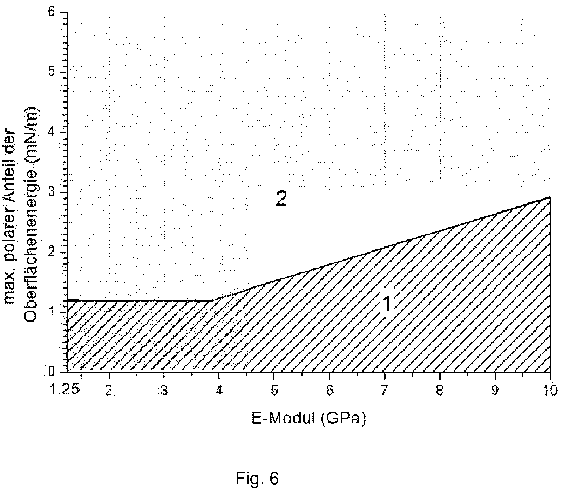

Figur 3 (für den ersten Aspekt der Erfindung) und Figur 6 (für den zweiten Aspekt der Erfindung) stellen als schraffierte Fläche (1) das durch die Gleichungen (2) und (2a) bedingte bevorzugte Merkmalfenster E-Modul gegen maximalen polaren Anteil der Oberflächenenergie dar. Hierzu ist anzumerken, dass die Schichten, die aus dem Stand der Technik nahegelegt sind, hinsichtlich ihrer Eigenschaftsfenster jeweils außerhalb des durch die Gleichungen (3) und (4) bzw. (2) und (2a) festgelegten Merkmalfensters liegen (der nicht-schraffierte Bereich (2)).
Dabei sei darauf hingewiesen, dass für die meisten Kunststoffanwendungen, insbesondere aber für Faserverbundkunststoffe eine möglichst geringe Oberflächenenergie und insbesondere ein möglichst geringer polarer Anteil der Oberflächenenergie wünschenswert sind.
Durch die oben beschriebene Verfahrensführung lassen sich überraschenderweise Korrosionsschutzschichten erzeugen, die ein besonders wünschenswertes Eigenschaftsfenster hinsichtlich des Verhältnisses E-Modul zu Oberflächenenergie beziehungsweise zu maximalem polaren Anteil der Oberflächenenergie besitzen. Dieses Eigenschaftsfenster bewirkt, dass im Verhältnis zu der gegebenen Härte besonders gute Widerstandsfähigkeit gegen aggressive Chemikalien, insbesondere gegen Laugen besteht.
Überraschenderweise hat sich herausgestellt, dass ein besonders guter Korrosionsschutz im Bereich siliziumorganischer, plasmapolymerer Beschichtungen genau dann erzielt werden kann, wenn die Beschichtung niederenergetisch ist und insbesondere einen geringen polaren Anteil der Oberflächenenergie aufweist (bevorzugt sind hier $\leq 3$ mN/m, weiter bevorzugt $\leq 2$ mN/m und besonders bevorzugt $\leq 1,5$ mN/m) und eben nicht dann, wenn eine intensive Fragmentierung des Precursors, welcher für die plasmapolymere Beschichtung verwendet wird, stattgefunden hat und auf diese Art und Weise eine Vielzahl von polaren Gruppen eingebaut wird.
Polare Gruppen in plasmapolymeren Schichten werden zumeist durch die Anwesenheit von Sauerstoff und/oder Wasser während des Plasmapolymerisationsprozesses, aber auch direkt nach der Beschichtung während der Belüftung der Vakuumanlage hervorgerufen.
Neben einem geringen Anteil an polaren Gruppen in der Beschichtung ist die Schicht gut vernetzt und so hart, dass sie insbesondere auch für Korrosionsschutz gebrauchsfähig ist. Dies wird dadurch sichergestellt, dass die erfindungsgemäßen Schichten über ein E-Modul 1,25 bis 10 GPa, bevorzugt 1,5 bis 9,0, besonders bevorzugt 2,0 bis 8.0 und weiter bevorzugt 2,5 bis 7,5 GPa verfügen.
Eine besonders gute Schichtqualität insbesondere im Sinne des Korrosionsschutzes erreicht man dann, wenn neben einem geringen polaren Anteil der Oberflächenenergie gleichzeitig ein hoher disperser (nicht-polarer) Anteil ($\geq$ 23 mN/m, bevorzugt ($\geq$ 25 mN/m, weiter bevorzugt ($\geq$ 27 mN/m) der Oberflächenenergie vorliegt.
Erfindungsgemäß bevorzugt ist ferner ein plasmapolymerer Festkörper bzw. eine plasmapolymere Schicht, wobei die Oberfläche einen Brechungsindex bei 550 nm von 1,4 bis 1,54, bevorzugt von 1,44 bis 1,54 besitzt.

Überraschenderweise besitzen die erfindungsgemäßen Schichten in ihrer bevorzugten Form einen Brechungsindex, der auf eine gute Eignung für den gewünschten Einsatzzweck hinweist. Je höher der Anteil an Si-O-Si-Struktureinheiten und eben nicht an $SiO_2$-Struktureinheiten in den erfindungsgemäßen Beschichtungen ist, desto größer ist bei gleicher Oberflächenenergie der E-Modul und die Härte. Daneben steigt der Brechungsindex an.

Erfindungsgemäß bevorzugt, insbesondere für den Einsatz als Trennschicht und/oder Korrosionsschutzschicht ist eine plasmapolymere Schicht, wobei die Schicht eine Schichtdicke von 5 nm bis 20 $\mu$m, bevorzugt 200 nm bis 10 $\mu$m und besonders bevorzugt 400 nm bis 5 $\mu$m besitzt.

Bei diesen Schichtdicken lassen sich besonders gut formerhaltende und dauerhafte Trennschichten und/oder Korrosionsschutzschichten erzeugen und technische Oberflächenrauhigkeiten abdecken, so dass auf besondere Glättungsverfahren verzichtet werden kann..

Bevorzugt ist eine erfindungsgemäße plasmapolymere Schicht, wobei die Härte der Schicht gemessen mittels Nanoindentation $\geq$ 0,5 GPa, bevorzugt $\geq$ 1 GPa und weiter bevorzugt $\geq$ 1,5 GPa beträgt.

Die Messung der Härte der erfindungsgemäßen Schichten erfolgt bevorzugt wie im Messbeispiel 1 beschrieben.

Die Tatsache, dass die erfindungsgemäßen Schichten bei gegebenem C/O-Verhältnis und E-Modul über verhältnismäßig hohe Härten verfügen, ist ebenfalls überraschend und war aus dem Stand der Technik nicht vorherzusagen. Gerade die Tatsache, dass eine Kombination von hohem E-Modul bzw. hoher Härte mit niedriger Oberflächenenergie bzw. einen niedrigen polaren Anteil der Oberflächenenergie vorliegen kann, macht die erfindungsgemäßen Schichten für den vorgesehenen Einsatzzweck besonders geeignet, weil sie sich als chemisch und mechanisch dauerhaft erweisen. Berücksichtigt man hierzu noch die Kombination der geeigneten Oberflächenenergien stellen die erfindungsgemäßen Schichten, insbesondere in den bevorzugten Varianten, eine deutliche Verbesserung gegenüber dem Stand der Technik dar.

Entsprechend dem Vorgesagten ist erfindungsgemäß bevorzugt eine plasmapolymere Schicht, wobei die Stoffmengenverhältnisse auf der Oberfläche der Schicht gemessen mittel XPS

O : Si 1,0 bis 2,0, bevorzugt 1,15 bis 1,7 und/oder

C : Si 1,1 bis 2,5, bevorzugt 1,3 bis 2,0

betragen.

Neben dem Verhältnis C/O haben sich auch die beschriebenen weiteren Stoffmengenverhältnisse als besonders geeignet erwiesen. Besonders bevorzugt ist erfindungsgemäß eine plasmapolymere Schicht, wobei für die Stoffmengenanteile auf der Oberfläche der Schicht gemessen mittel XPS gilt:

O : 25 - 50 at%, bevorzugt 28 - 45 at%
Si: 22 - 28 at%, bevorzugt 23 - 27 at%
C : 28-50 at%, bevorzugt 30 - 50 at%, weiter bevorzugt 32 - 47 at%

jeweils bezogen auf die Gesamtzahl der in der Schicht enthalten Atome ohne H.

Die jeweiligen Stoffmengenbestimmungen erfolgen mittels XPS, im Zweifelsfall wie in Messbeispiel 2 beschrieben.

Bei der Abscheidung der erfindungsgemäßen Schichten wird gegenüber dem unkontaktierten Zustand (frei floatender Aufbau) sowohl eine deutlich erhöhte Abscheiderate erreicht, als auch eine gute Zugänglichkeit der Beschichtung in Bezug auf enge Vertiefungen des zu beschichtenden Bauteils.

Der Anwender wird darauf achten, dass dem Plasmapolymerisationsprozess nur in geringen Mengen sauerstoffhaltige Gase zugeführt werden, ebenso wird er auf eine geringe Leckrate (bevorzugt $\leq$ 5 sccm ermittelt über eine Druckanstiegskurve über den Zeitraum von mind. 1 Std.) und eine geringe Wasserlast im Vakuumkessel achten.

Teil der Erfindung ist auch die Verwendung einer erfindungsgemäßen plasmapolymeren Schicht (insbesondere der für den ersten Aspekt der Erfindung bevorzugten) als Trennschicht in einem Formwerkzeug.

In diesem Zusammenhang ist es bevorzugt, dass die Trennung gegenüber einem Kunststoff, bevorzugt gegenüber einem Faserverbundstoff erfolgt.

Ganz besonders bevorzugt ist erfindungsgemäß, dass die Verwendung so erfolgt, dass die Trennung gegenüber einem Kunststoff erfolgt, ausgewählt aus der Gruppe bestehend aus Elastomer, Thermoplast und Duroplast, wobei der jeweilige Kunststoff beispielsweise ein faserverstärkter Kunststoff (FVK), ein Klebstoff, eine Dichtmasse, ein Schaum oder ein spritzgegossener Kunststoff sein kann.

In den erfindungsgemäßen Verwendungen, insbesondere den bevorzugten erfindungsgemäßen Verwendungen, können die erfindungsgemäßen Schichten besonders gut ihre Eigenschaften zu tragen kommen lassen.

Teil der Erfindung ist auch die Verwendung einer erfindungsgemäßen Schicht (insbesondere der für den ersten Aspekt der Erfindung bevorzugten) zur Verbesserung der Reinigungsfähigkeit eines Festkörpers mit Wasser, wässrigen Substanzen, $CO_2$ und/oder Lösungsmitteln.

Teil der Erfindung ist auch die Verwendung einer erfindungsgemäßen plasmapolymeren Schicht (insbesondere der für den zweiten Aspekt der Erfindung bevorzugten) zur Verbesserung des Korrosionsschutzes an der Oberfläche. Eine Verbesserung des Korrosionsschutzes liegt zumindest dann vor, wenn durch die Einwirkung starker Säuren und Laugen eine gegenüber dem unbeschichteten Zustand verlangsamte Oberflächenveränderung stattfindet. Es ist bevorzugt hierzu als Schnelltest, die beschichtete Oberfläche mit 25%iger Schwefelsäure bei 65°C über einen Zeitraum von 15 bis 60 min zu prüfen und mit einer unbeschichteten gleichen Oberfläche zu vergleichen, die der gleichen Belastung ausgesetzt wurde. Analog kann die Laugenbeständigkeit bevorzugt mit 1 molarer Natronlauge bei Raumtemperatur, bevorzugt bei 60°C über einen Zeitraum von 15 bis 60 min geprüft werden. Eine Verbesserung des Korrosionsschutzes liegt dann vor, wenn der Test auf Laugen- oder Säurenbeständigkeit, bevorzugt beide Tests eine durch die erfindungsgemäße Beschichtung verlangsamte Oberflächenveränderung, bevorzugt feststellbar mit dem unbewaffneten menschlichen Auge, belegen.

Bevorzugt ist eine erfindungsgemäße Verwendung, wobei die Oberfläche aus einem Metall oder einer Metalllegierung besteht oder ein Metall oder eine Metalllegierung umfasst.

Metalle sind im Sinne dieses Textes die Alkalimetalle, die Erdalkalimetalle, die Elemente mit den Ordnungszahlen 13, 21 bis 31, 39 bis 50, 57 bis 83 sowie 89 bis 94, sofern sie als Festkörper vorliegen. Unter bestimmten Umständen können im Sinne dieser Erfindung auch Germanium und Antimon sowie die Übergangsmetalle Bor, Silizium, Arsen und Tellur zu den Metallen gezählt werden.

Bevorzugte Metalle, die durch die erfindungsgemäßen Schichten geschützt werden können, sind Aluminium, Eisen, hier insbesondere Stahl, Magnesium, Kupfer, Silber, Zink, Nickel, Titan und deren Legierungen.

Teil der Erfindung ist auch ein Festkörper, umfassend ein Substrat und auf dieses Substrat aufgebracht eine erfindungsgemäße Beschichtung. Diesem Festkörper werden somit - zumindest im Bereich der erfindungsgemäßen Beschichtung - die vorteilhaften Eigenschaften in der erfindungsgemäßen Beschichtung an seiner Oberfläche verliehen.

Dementsprechend ist erfindungsgemäß bevorzugt (insbesondere für den ersten Aspekt der Erfindung) ein Festkörper, ausgewählt aus der Gruppe bestehend aus Vorrichtung zur Formgebung von FVK oder anderen Kunststoffen, Presse, Umformwerkzeug, Spritzgusswerkzeug, Gießwerkzeug, statische Dichtungen, Komponenten von Klebstoffapplikationsvorrichtung, Pfannen und anderen Garvorrichtungen, Photovoltaikmodulen und anderen der Stromerzeugung dienenden Elementen, Bauelementen für die Verpackungsindustrie, wie z.B. Schieber oder Transportelemente, Komponenten von Lackier- und Druckvorrichtungen, wie z.B. Rohrleitungen, Abdeckungen oder Farbbehälter.

Bevorzugt ist insbesondere ein erfindungsgemäßer Festkörper, wobei das Substrat im Sinne des zweiten Aspektes der Erfindung besteht aus oder umfasst an seiner Oberfläche ein Metall oder eine Metalllegierung und auf seiner Oberfläche im Bereich des Metalls oder der Metalllegierung angebracht eine erfindungsgemäße Beschichtung ist.

Bevorzugt (insbesondere im Sinne des zweiten Aspektes der Erfindung) ist ein erfindungsgemäßer Festkörper gebildet aus der Gruppe bestehend aus Wärmeüberträger, Automobilfelge, medizinischem Gerät oder Werkzeug, Beschlag für Möbel, Auszugseinheit z.B. für Backöfen, Küchen oder Möbel; Zier- und Funktionselement für Fahrzeuge, wie z.B. Zierleisten und Geländer.

Diese Gebrauchsgegenstände als erfindungsgemäße Festkörper lassen sich besonders effektiv mit der erfindungsgemäßen Beschichtung schützen.

Teil der Erfindung ist auch die Verwendung einer erfindungsgemäßen Schicht zur Verbesserung der Reinigungsfähigkeit eines Festkörpers, wie oben insbesondere im Sinne des zweiten Aspektes der Erfindung beschrieben jeweils ohne entsprechende Schicht definiert, mit Lösemitteln, wässrigen Reinigern und/oder Trockeneis, denn aufgrund der günstigen Oberflächeneigenschaften (vgl. oben) ist es möglich, mit den erfindungsgemäßen Korrosionsschichten auch das Reinigungsverhalten von Oberflächen positiv zu beeinflussen. Bevorzugtes Reinigungsmittel ist Wasser.

Teil der Erfindung ist auch ein Verfahren zum Herstellen eines beschichteten Substrats, umfassend die Schritte:

a) Bereitstellen eines zu beschichtenden Substrates und

b) Beschichten des Substrates mit einer erfindungsgemäßen Beschichtung.

Bevorzugt ist ferner ein Verfahren zur Herstellung eines Festkörpers mit Korrosionsschutz auf seiner Oberfläche, umfassend die Schritte

a) Bereitstellen eines Festkörpers mit Metall oder Metalllegierung an seiner Oberfläche und

b) Abscheiden einer erfindungsgemäßen Schicht wenigstens auf einen Teil seiner metallhaltigen bzw. metalllegierungshaltigen Oberfläche,

wobei das erfindungsgemäße (plasmapolymere) Beschichtungsverfahren so geführt wird, dass ein Niederdruck-Hochfrequenzplasma verwendet wird, vorzugsweise mit einer Frequenz von 13,56 MHz. Dabei wird das zu beschichtende metallische Bauteil bevorzugt leitfähig mit der Elektrode verbunden. Die Elektrode ist derart gewählt, dass sich während des Plasmapolymerisationsprozesses kein oder nur ein ganz kleiner Self-Bias von $\leq 20$ V, bevorzugt $\leq 10$ V ausbildet. Sollte dies nicht möglich sein, so wird der Fachmann z.B. das Verhältnis von Elektrodenfläche zu Massefläche (Kammerwandung) gezielt vergrößern, um den (bevorzugten) Arbeitsbereich zu erreichen.

Für den Anwender erwachsen aus dieser Vorgehensweise zwei wesentliche Vorteile: Es gibt keine Einschränkung in Bezug auf die Aufskalierbarkeit des Beschichtungsprozesses, denn die zu beschichtende Bauteiloberfläche kann sehr, sehr groß werden, z.B. größer als 10 oder 20 m$^2$. Damit lässt sich die Beschichtung besonders wirtschaftlich realisieren.

Ferner findet kein bzw. nur ein sehr energiearmer Ionenbeschuss der sich bildenden Beschichtung statt, so dass keine unnötige Oxidation hervorgerufen wird.

Nachfolgend wird die Erfindung anhand von Beispielen näher erläutert:

## Messbeispiele

Messbeispiel 1 E-Modul

Die Nanoindentierung ist eine Prüftechnik, mit der über eine feine Diamantspitze (dreiseitige Pyramide [Berkovich], Radius wenige 100nm) die Härte von Oberflächenbeschichtungen ermittelt werden kann. Es wird hierbei entgegen der makroskopischen Härtebestimmung (wie z.B. Vickershärte) nicht die durch eine Normalkraft eingeprägte verbliebene Indentierungsmulde vermessen, sondern eine eindringtiefenabhängige Querschnittsfläche des Nanoindentors angenommen. Diese tiefenabhängige Querschnittsfläche wird über eine Referenzprobe mit bekannter Härte ermittelt (i.d.R. Fused Silica).

Die Nanoindentierung verwendet während der Aufbringung der Normalkraft eine empfindliche Auslenkungssensorik (kapazitive Platten), mit der die Eindringtiefe bei steigender und wieder sinkender Normalkraft präzise gemessen werden kann - ganz anders als bei der klassischen Vorgehensweise. Die Normalkraft-Eindringtiefe-Kurve gibt während der Anfangsphase der Entlastung in situ die Steifigkeit der Probe an. Mithilfe der von der Referenzprobe bekannten Querschnittsfläche des Nanoindentors kann so das Elastizitätsmodul und die Härte der Probe bestimmt werden. Die maximale Prüfkraft für die Nanoindentierung liegt in der Regel unterhalb von 15 mN.

Zur Messung der reinen Eigenschaften der Beschichtung ohne Beeinflussung durch das Substrat wird eine Faustregel von 10% der Schichtdicke verwendet. Tiefer gehendere Eindringkurven beinhalten einen Einfluss durch das verwendete Substrat. Bei steigenden Eindringtiefen von über 10% der Schichtdicke nähern sich die gemessenen Werte für Elastizitätsmodul und Härte sukzessive an die des Substrats an. Die beschriebene Auswertung nach diesem Messverfahren wird nach Oliver & Pharr benannt [W.C. Oliver, G.M. Pharr, An improved technique for determining hardness and elastic modulus using load and displacement sensing indentation experiments, J. Material Res. (1992) Vol. 7, No. 6, 1564-1583]

Zur einfacheren Variation der Eindringtiefen bei verschiedenen Lasten wird das sogenannte multiple Be- und Entlastungsverfahren, kurz Multiindentierungsverfahren, verwendet. Hierbei werden auf einer festen Stelle segmentweise Be- und Entlastungen vorgenommen. Die lokalen Belastungsmaxima werden dabei kontinuierlich gesteigert. Auf der festen Stelle können so tiefenabhängige Werte des Elastizitätsmoduls und der Härte ermittelt werden. Zusätzlich werden aus statistischen Zwecken auf einem Messfeld verschiedene unbeeinflusste Stellen der Probe ebenfalls angefahren und getestet. Durch Vergleich zwischen Einzelindentierung und Multiindentierungsverfahren haben Schiffmann & Küster nachgewiesen, dass es nur sehr kleine Abweichungen zwischen den ermittelten Werten der beiden Verfahren gibt [K. I. Schiffmann, R. L.A. Küster; Comparison of Hardness and Young's Modulus by Single Indentation and Multiple Unloading Indentation. In: Zeitschrift für Metallkunde 95 (2004) 5, 311-316]. Zur Kompensation werden längere Haltezeiten zur Verhinderung von Kriecheffekten der Piezoscanner vorgeschlagen [K. I. Schiffmann, R. L.A. Küster; Comparison of Hardness and Young's Modulus by Single Indentation and Multiple Unloading Indentation. In: Zeitschrift für Metallkunde 95 (2004) 5, 311-316].

Dementsprechend wurde beispielsweise bei Proben aus Ausführungsbeispiel 2 (Tabelle 2) mit 10 Multiindents pro Stelle mit maximal 0,055 mN gemessen. Die Multiindents haben lokale Kraftmaxima, die dann auf 20% der Kraft reduziert wurden. Diese Entlastungskurven wurden in der Form einer Tangente von 98 bis 40% ausgewertet. Es wurden 10 Messpunkte für die Statistik und Homogenität getestet. Die Entfernung der Messpunkte betrug 50 $\mu$m, um Einflüsse wie beispielsweise plastische Deformationen der zu prüfenden Schicht durch vorherige Messungen zu vermeiden. Die Schichtdicke betrug 1839 nm. Für die Einhaltung der Faustformel für die Eindringtiefe von max. 10% der Schichtdicke sind die Entlastungskurven bei den Multiindents des gezeigten Beispiels bis zur maximalen Kraft von 0,055 mN zulässig für die Auswertung. Bei geringeren Schichtdicken ist auf die zugehörige max. lokale Kraft zu achten, um die 10% - Regel nicht zu überschreiten.

Für die Nanoindentierungen der Ausführungsbeispiele wurde ein Universal Material Tester (UMT) mit Nanoindentierungsmodul Nano-Head (NH2) der Fa. CETR (nunmehr unter Fa. Bruker AXS S.A.S.) mit entsprechender Vibrationsdämpfungstechnik (Minus k) in einer thermisch und akustischen Isolierungskammer eingesetzt.

Entsprechend dem Multiindentierungsverfahren werden als Beispiel bei Proben, welche entsprechend der 2ten Zeile der Tabelle 1 (Ausführungsbeispiele, Beispiel 1) hergestellt wurden, wurde, mit 10 Multiindents pro Stelle mit maximal 0,055 mN gemessen. Die Multiindents haben lokale Kraftmaxima, die dann auf 20% der Kraft reduziert wurden. Diese Entlastungskurven wurden in der Form einer Tangente von 98 bis 40% ausgewertet. Es wurden 10 Messpunkte für die Statistik und Homogenität getestet. Die Entfernung der Messpunkte betrug 50 $\mu$m, um Einflüsse wie beispielsweise plastische Deformationen der zu prüfenden Schicht durch vorherige Messungen zu vermeiden. Die Schichtdicke betrug 1839 nm. Für die Einhaltung der Faustformel für die Eindringtiefe von max. 10% der Schichtdicke sind die Entlastungskurven bei den Multiindents des gezeigten Beispiels bis zur maximalen Kraft von 0,055 mN zulässig für die Auswertung. Bei geringeren Schichtdicken ist auf die zugehörige max. lokale Kraft zu achten, um die 10% - Regel nicht zu überschreiten.

Die maximale Kraft für die Eindringtiefe und die korrespondierende Entlastungskurve ist also hier im Zweifelsfall ≤ 0,055 mN, bevorzugt ist sie bei Schichtdicken von ≤ 1000 nm im Zweifelsfall ≤ 0,020 mN.

Messbeispiel 2 XPS-Messungen

Die XPS-Messungen werden für die Bestimmung von Stoffmengenverhältnissen für die erfindungsgemäßen Schichten eingesetzt. Hierzu wird wie folgt vorgegangen:
Die XPS-Untersuchungen erfolgten mit einem VG 220i-XL-System. (Fa. VG Scienta) Parameter: Magnetlinsenmode, Abnahmewinkel der Photoelektronen 0°, monochromatisierte AlK$\alpha$-Anregung, Constant Analyser Energy-Mode (CAE) mit 70 eV Passenergie in Übersichtsspektren sowie 20 eV in energetisch hochaufgelösten Linienspektren, Analysenfläche: 0,65 mm ø, die Neutralisation von elektrisch nichtleitenden Proben erfolgt mit niederenergetischen Elektronen (4 eV). Die Nachweisempfindlichkeit der Methode ist elementspezifisch und liegt bei ca. 0.1 at%, d.h.ca. 1000 ppm. Zur Kompensation von Aufladungseffekten wird die C-C-Spezies zuzuordnende C1s-Hauptphotoemmissionslinie bei der Auswertung auf 285 eV festgelegt, dadurch verschieben sich die Lagen der weiteren Photolinien entsprechend.

Der XPS-Spektrometer wurde unter Berücksichtigung der ASTM-Norm E902-94 eingerichtet. ASTM-Norm E 1078 - 90 wurde im Hinblick auf das Probenhandling vor und während der Analyse eingesetzt. Für die Verarbeitung der gewonnen Messdaten wurden die Normen ASTM E 996-94 und E995-95 heran gezogen. Mitgeltende Unterlagen sind die in den Normen benannten Referenzen.

Mit Hilfe dieser Vorgehensweise ergaben sich sowohl die elementaren Zusammensetzungen, als auch die Si 2p-Peakverschiebungen, wie sie in Tabelle 1 und 2 dargestellt sind.

Messbeispiel 3 Oberflächenenergie

Die Oberflächenenergie wird gemäß der DIN 55660-2 vom Dez. 2011 mit einem Kontaktwinkelmessgerät G2 der Fa. Krüss bestimmt. Dabei werden als Prüfflüssigkeiten Wasser, Dijodmethan und Ethylenglykol mit hohem Reinheitsgrad verwendet. Die Prüfflüssigkeiten weisen folgende Kenndaten auf:

| | | | | | | | |
|---|---|---|---|---|---|---|---|
| Wasser | Oberflächenenergie: | 72,8 | mN/m, | polarer | Anteil: | 51,0 | mN/m |
| Dijodmethan | Oberflächenenergie: | 50,8 | mN/m, | polarer | Anteil: | 0,0 | mN/m |
| Ethylenglykol | Oberflächenenergie: | 47,7 | mN/m, | polarer | Anteil: | 16,8 | mN/m |

Das verwendete Messverfahren ist die dynamische Messung (fortschreitender Kontaktwinkel), bei der während der Flüssigkeitszufuhr der Randwinkel bestimmt wird. Die Einstellung der Basislinie erfolgt im Zweifelsfall händisch, horizontal in der Mitte zwischen der Spritzenspitze und dem Spiegelbild. Der Nadelabstand wird auf ca. 2 mm eingestellt. Vor der Messung wird die Oberfläche ggf. mit Aceton gesäubert (einmalige ganz leichtes Abwischen mit Aceton und einem fuselfreien Tuch), um die Gefahr von Fehlmessungen zu reduzieren.

Als Prüfflüssigkeitsmenge werden 6 $\mu$l mit einer Dosierrate von 11,76 $\mu$l/min verwendet. Die eigentliche Messung beginnt nach 5 s, dies entspricht einem Vorschubvolumen von ca. 1 $\mu$l. Es werden pro Flüssigkeit 3 Tropfen aufgesetzt. Die jeweiligen Ergebnisse werden gemittelt.

Die Auswertung der Kontaktwinkel sowie der Oberflächenenergie und des polaren Anteils der Oberflächenenergie erfolgte über die Software Drop Shape Analysis (DSA) for Windows (Version 1.91.0.2) der Firma Krüss. Dabei wurde für die Bestimmung des Kontaktwinkels das Polynomverfahren 2 verwendet. Die Auswertung für Oberflächenenergien bis 30 mN/m wurde nach Wu [S. Wu, Calculation of interfacial tension in polymer systems, Journal of Polymer Science, Part C: Polymer Symposia (1971), Vol. 34, Issue 1, 19-30] und für Oberflächenenergien über 30 mN/m nach Owens-Wendt-Rabel-Kaelble vorgenommen. Die Auswertung erfolgte ohne Fehlergewichtung.

Es ergaben sich die in Tabelle 1 und 2 angegebenen Werte für die Oberflächenenergie und deren polaren Anteil.

## Ausführungsbeispiele

Beispiel 1

Zur Herstellung aller Proben wurde eine $1m^3$ - Plasmapolymerisationsanlage benutzt, wie sie in [Vissing, K.: Aufskalierung plasmapolymerer Beschichtungsverfahren, Dissertation, Culliver, (2008) ISBN 978-3-86727-548-4] beschrieben ist. Sie verfügte vorliegend jedoch abweichend über ein Elektrodensystem mit einer offenen Fläche von ca. $2,9\ m^2$, so dass der Self-Bias dieser Anlage im Bereich der in der Tabelle 1 angegebenen Arbeitsparameter, gemessen über die Matchbox des HF-Systems, zuverlässig < 10 V betrug.

Alle Proben wurden unmittelbar auf der Elektrode platziert, so dass sich das Plasma auch bei den flachen, nichtleitenden Proben, wie z.B. Wafern oder Glasobjektträgern, trotzdem oberhalb problemlos ausbilden konnte.

Die Gesamtleckrate der Anlage wurde zuvor über die Druckanstiegsmethode mit kleiner 0,3 mbar l/s bestimmt.

Nach einer Sauerstoffvorbehandlung der Proben wurde ein Gasfluss von 60 sccm HMDSO und 30 sccm $O_2$ bei einem Arbeitsdruck (geregelt über ein sogenanntes Butterflyventil) von 0,016 mbar eingestellt (Referenzbeispiel und Beispiele 1 und 2, vergleiche Tabelle 1). Nach der Einregulation des Druckes wurde das Plasma, in Beispiel 1 mit einer Vorwärtsleistung wie in der Tabelle unter "Leistung" angegeben, gezündet. Dieser Zustand wurde so lange aufrechterhalten, bis die gewünschte Schichtdicke erreicht war. Danach wurde die Leistung auf Null gesetzt und damit das Plasma ausgeschaltet. Anschließend wurde der Gasfluss ebenfalls auf Null reduziert, so dass anschließend der Belüftungsvorgang eingeleitet werden konnte.

Die so entstehende Beschichtung verfügt über ein E-Modul (gemessen mittels Nanoindentation) wie in Tabelle 1 angegeben. Für die Beschichtung aus Beispiel 2 (Tabelle 1) z. B. 7 GPa bei einem C/O-Verhältnis von 1,22 und einer Oberflächenenergie von 27,2 mN/m.

Alle verwendeten Plasmaparameter (HF-Leistung, Gasflüsse, Druck) für die Beispiele sind der Tabelle 1 zu entnehmen, ebenso wie die dazugehörigen Messergebnisse und berechnete Größen.

Stellt man während der Beschichtung folgende Gasflüsse ein: HMDSO 60 sccm und $O_2$ 30 sccm und verwendet eine HF-Leistung von 1500 W wird eine Beschichtung abgeschieden, welche sich durch die Zusammensetzung und das Eigenschaftsprofil entsprechend Tabelle 1 auszeichnet. Damit ist eine Beschichtung beschrieben, welche sich durch einen sehr hohen E-Modul bei einem C/O-Verhältnis von 1,22 auszeichnet. Ferner ist trotz des hohen E-Moduls eine Beschichtung abgeschieden mit geringer Oberflächenenergie und geringem polaren Anteil, welche sich hervorragend als Trennschicht für die CFK-Verarbeitung eignet. Dagegen zeigt das nicht erfindungsgemäße Referenzbeispiel, dass, obwohl die Gasflüsse wie in Beispiel 1 und 2 sind, nicht das erfindungsgemäße Eigenschaftsfenster erreicht wird. Dies gilt auch z.B. für die Beispiele aus der WO 03/002269.

**Tabelle 1**

| Hinweis | HMDSO-Fluss [sccm] | O2-Fluss [sccm] | Leistung [W] | Druck [mbar] | E-Modul [GPa] | C [at-%] | O [at-%] | Si [at-%] | O/Si | C/Si | C/O | Si 2p-Maximum peaklage [eV] | OFE [mN/m] | polarer Anteil [mN/m] |
|---|---|---|---|---|---|---|---|---|---|---|---|---|---|---|
| Referenzbeispiel | 60 | 30 | 500 | 0,016 | 0,9 | 45,7 | 29,1 | 25,2 | 1,15 | 1,81 | 1,57 | 102,6 | 22,5 | 0,53 |
| Beispiel 1 | 60 | 30 | 900 | 0,016 | 2,8 | 44,4 | 30,3 | 25,3 | 1,20 | 1,75 | 1,47 | 102,65 | 23,4 | 0,79 |
| Beispiel 2 | 60 | 30 | 1500 | 0,016 | 7,0 | 41,0 | 33,7 | 25,3 | 1,33 | 1,62 | 1,22 | 102,6 | 27,2 | 2,04 |
| Beispiel 3 | 45 | 45 | 1500 | 0,016 | 12,8 | 37,9 | 36,7 | 25,5 | 1,44 | 1,49 | 1,03 | 102,8 | 29,0 | 3,40 |
| Beispiel 4 | 30 | 60 | 1500 | 0,016 | 29,3 | 32,7 | 41,9 | 25,1 | 1,67 | 1,30 | 0,78 | 103,1 | 30,5 | 4,89 |

Beispiel 2:

Eloxiertes Aluminium (Unidal 7090; Eloxaldicke = 14 - 16 $\mu$m (Eloxalhärte = 200 - 400 HV; verdichtet) wird z.B. zu Instrumententrägern für medizintechnische Anwendungen verarbeitet. Dabei muss die Oberfläche gegen die Einwirkung von starken Laugen und heißem Wasserdampf während der Desinfektion und Sterilisation geschützt werden, um einen konstanten optischen Eindruck zu gewährleisten. Dabei kommen aus optischen und kostentechnischen Gründen keine glättenden Verfahren als Vorbehandlungsverfahren in Betracht, so dass durch eine erfindungsgemäße plasmapolymere Korrosionsschutzschicht die Metalloberfläche geschützt werden konnte.

Die Beschichtungsbedingungen waren:

Verwendung einer [5 m$^3$ - Plasmapolymerisationsanlage mit einem flächigen HF-Elektrodensystem [Vissing, K.: Aufskalierung plasmapolymerer Beschichtungsverfahren, Dissertation, Culliver, (2008) ISBN 978-3-86727-548-4]. Sie verfügte vorliegend jedoch abweichend über ein Elektrodensystem mit einer offenen Fläche von ca. 8 m$^2$, so dass der Self-Bias dieser Anlage, gemessen über die Matchbox des HF-Systems, zuverlässig < 10 V betrug.

Alle Proben wurden unmittelbar auf der Elektrode platziert, so dass sich das Plasma auch bei den flachen, nichtleitenden Proben, wie z.B. Wafern oder Glasobjektträgern, trotzdem oberhalb der Proben problemlos ausbilden konnte.

Die Gesamtleckrate der Anlage wurde zuvor über die Druckanstiegsmethode mit kleiner 0,3 mbar l/s bestimmt. Nach einer Vorbehandlung der Proben mit einem Sauerstoffplasma wurde bei einem Arbeitsdruck von 0,028 mbar geregelt über ein Butterflyventil, je 200 sccm HMDSO und $0_2$ kontinuierlich eingelassen. Zur Plasmabildung wurde eine Zeit von 4500 s eine Vorwärtsleistung von 4200 W benutzt für. Danach wurde die Leistung auf Null gesetzt und damit das Plasma ausgeschaltet. Anschließend wurde der Gasfluss ebenfalls auf Null reduziert, so dass anschließend der Belüftungsvorgang eingeleitet werden konnte.

Die gebildete plasmapolymere Beschichtung wies eine Schichtdicke von ca. 2 $\mu$m auf, verfügte über eine Oberflächenenergie von 24,7 mN/m mit einem polaren Anteil von 1,1 mN/m. Korrespondierend wurden ein statischer Wasserrandwinkel von 100° gemessen. Der E-Modul der Beschichtung betrug 3,05 GPa gemessen mittels Nanoindentation.

**Tabelle 2**

| Art | HMDS O₂-Fluss | Leistung | Druck | E-Mon [W] | C [at-%] | O [at-%] | S [at-%] | O/Si | C/Si | O/C | Si-Mixel | O Film | polaret |
|---|---|---|---|---|---|---|---|---|---|---|---|---|---|
| Beispiel 1 | 200 | 200 | 4200 | 0,028 | 3,5 | 44,1 | 30,9 | 25,0 | 1,24 | 1,76 | 1,43 | 102,65 | 24,3 | 1,10 |
| Gegenbeispiel | 100 | 300 | 4200 | 0,028 | 9,9 | 32,9 | 42,2 | 24,9 | 1,69 | 1,32 | 0,78 | 103,1 | 31,7 | 4,10 |
| Beispiel 2 | 60 | 30 | 1200 | 0,016 | 5,0 | 42,8 | 32,0 | 25,2 | 1,27 | 1,70 | 1,34 | 102,6 | 25,2 | 1,10 |

Geprüft wurde die Wirksamkeit der Korrosionsschutzschicht durch das Auflegen eines Tropfens einer NaOH-Lösung (1 molar) für einen Zeitraum von 1 Std. bei Raumtemperatur.

Es zeigte sich keine sichtbare Veränderung der Oberfläche, wogegen unbeschichtete oder schlecht beschichtete Oberflächen sofort eine Reaktion durch Blasenbildung aufweisen und eine deutlich Veränderung der Prüffläche zu beobachten ist. Im unbeschichteten Fall ist ein kleines Loch entstanden.

Ebenfalls gute Korrosionsstabilität konnte mit Hilfe eines Schwefelsäuretest (15 min, in 25% Schwefelsäure bei 65°C) beobachtet werden.

Das Gegenbeispiel aus Tabelle 2 zeigt, dass es bei ungeeigneter Prozessführung in der gleichen Anlage zwar möglich ist den gewünschten E-Modul zu erreichen, jedoch der polare Anteil deutlich zu groß ausfällt und damit auch die Lage des Si 2p-Peaks in unerwünschte Bereiche verschoben ist. Die Prüfung der Korrosionsbeständigkeit zeigt dementsprechend auch nur einen mittelmäßigen Korrosionsschutz sowohl im sauren als auch im basischen Bereich.

Die Ergebnisse aus diesem Beispiel sowie die Prozessparameter finden sich in der Tabelle 2.

Ausführungsbeispiel 3:

Zur Herstellung von einnähbaren Aluminiumelementen für Textilien, welche gebleicht werden, ist ein exzellenter Korrosionsschutz im hohen pH-Werte - Bereich ebenso notwendig, wie eine gewisse mechanische Beständigkeit.

Um für derartige Ansprüche Lösungen bereit stellen zu können wurden Proben aus Al 99,5 - Blech EN AW-1050A (Rot/Schwarz) H14 EN 573-3 EN 485-1,2,4 nach einer klassischen Lösungsmittelentfettung gründlich mit einem mit Acton getränkten Tuch mit Hilfe eines Sauerstoffplasma feingereinigt, um anschließend unmittelbar mit der Beschichtung, wie sie weiter unten erläutert wird, fortzufahren.

Zur Herstellung aller Proben wurde eine 1m$^3$ - Plasmapolymerisationsanlage benutzt, wie sie in [Vissing, K.: Aufskalierung plasmapolymerer Beschichtungsverfahren, Dissertation, Culliver, (2008) ISBN 978-3-86727-548-4] beschrieben ist. Sie verfügte vorliegend jedoch abweichend über ein Elektrodensystem mit einer offenen Fläche von ca. 2,9 m$^2$, so dass der Self-Bias dieser Anlage, gemessen über die Matchbox des HF-Systems, zuverlässig < 10 V betrug.

Alle Proben wurden unmittelbar auf der Elektrode platziert, so dass sich das Plasma auch bei den flachen, nichtleitenden Proben, wie z.B. Wafern oder Glasobjektträgern, trotzdem oberhalb problemlos ausbilden konnte.

Die Gesamtleckrate der Anlage wurde zuvor über die Druckanstiegsmethode mit kleiner 0,3 mbar l/s bestimmt.

Nach einer Sauerstoffvorbehandlung der Proben wurde ein Gasfluss von 60 sccm HMDSO und 30 sccm $O_2$ bei einem Arbeitsdruck (geregelt über ein sogenanntes Butterflyventil) von 0,016 mbar eingestellt. Nach der Einregulation des Druckes wurde das Plasma, in Beispiel 2 (Tabelle 2) mit einer Vorwärtsleistung von 1200 W, gezündet. Dieser Zustand wird so lange aufrechterhalten, bis die gewünschte Schichtdicke erreicht ist. Danach wird die Leistung auf Null gesetzt und damit das Plasma ausgeschaltet. Anschließend wird der Gasfluss ebenfalls auf Null reduziert, so dass anschließend der Belüftungsvorgang eingeleitet werden kann.

Die so entstehende Beschichtung aus Beispiel 2 (siehe Tabelle 2) verfügt über ein E-Modul (gemessen mittels Nanoindentation) von ca. 5,0 GPa bei einem C/O-Verhältnis von 1,34 und einer Oberflächenenergie von 25,2 mN/m mit einem polaren Anteil von 1,1 mN/m.

Geprüft wurde die Laugenbeständigkeit mit Hilfe eine NaOH-Testes, bei dem 1molare NaOH für eine Stunde bei Raumtemperatur auf die Oberfläche gegeben wurde. Es war weder mit dem unbewaffnetem Auge, noch mit einem Lichtmikroskop Korrosionsspuren (Lochfraß oder Schichtunterwanderung) erkennbar. Die mechanische Stabilität wurde an Reißverschlusselementen durch deren Gebrauch geprüft. Es ergab sich, dass die Elemente auch nach mechanischem Gebrauch keine Korrosionsspuren im NaOH-Test aufwiesen. Im Vergleich hierzu zeigen ungeschützte Oberflächen sofort einen starken flächigen Angriff. Proben mit unzureichender Beschichtung weisen Lochfraß auf.

**Patentansprüche**

1. Plasmapolymerer Festkörper, insbesondere plasmapolymere Schicht, wobei die Untergrenze des E-Moduls der Beschichtung durch folgende FunktioGen (1) bestimmt ist:

$$E = 25 - 31,5 * x + 13,5 * x^2 - 1,85 * x^3 \qquad (1)$$

mit

x = C/O Verhältnis ermittelt mittels XPS
E = E-Modul [GPa]
für E $\geq$ 1,25 GPa und
x $\geq$ 0,5 und $\leq$ 2,0

wobei auf der Oberfläche der Schicht gemessen mittel XPS für das Maximum des Si 2p - Peaks gilt:

für E-Modul < 10 GPa: 102,5 - 102,8 eV
für E-Modul 10-20 GPa: 102,7 - 103,1 eV und bevorzugt
für E-Modul > 20 GPa: > 103,0 eV

2. Plasmapolymerer Festkörper, insbesondere plasmapolymere Schicht nach Anspruch 1, wobei der maximale polare Anteil der Oberflächenenergie der Oberfläche durch folgende Funktionen (2) oder (2a) bestimmt ist:

$$\sigma(p) = 0,28 * E + 0,106 \qquad (2)$$

oder

$$\sigma(p) = 1,2 \qquad (2a)$$

je nachdem welcher Wert der Funktionen (2) und (2a) der größere ist,
mit

$\sigma(p)$ = polarer Anteil der Oberflächenenergie [mN/m]
E = E-Modul [GPa]
für E = 1,25 - 30

und/oder
die Oberflächenenergie der Oberfläche hinsichtlich ihrer Obergrenze durch folgende Funktion (3) bestimmt ist:

$$\sigma = 0,9 *E + 21,7 \qquad (3)$$

und die Oberflächenenergie der Oberfläche hinsichtlich ihrer Untergrenze durch folgende Funktion (4) bestimmt ist:

$$\sigma = 0,25 *E + 22,25 \qquad (4)$$

mit

$\sigma$ = Oberflächenenergie [mN/m]
E = E-Modul [GPa].

3. Plasmapolymerer Festkörper, insbesondere plasmapolymere Schicht nach Anspruch 1 oder 2, wobei die Oberfläche über einen Brechungsindex bei 550 nm von 1,4 bis 1,54 verfügt.

4. Plasmapolymerer Festkörper, insbesondere plasmapolymere Schicht nach einem der vorangehenden Ansprüche, wobei die Schicht eine Schichtdicke von 5 nm - 20 $\mu$m, bevorzugt 200 nm - 10 $\mu$m und besonders bevorzugt 400 nm - 5 $\mu$m besitzt.

5. Plasmapolymerer Festkörper, insbesondere plasmapolymere Schicht nach einem der vorangehenden Ansprüche, wobei die Härte der Schicht gemessen mittels Nanoindentation $\geq$ 0,5 GPa, bevorzugt $\geq$ 1 GPa, weiter bevorzugt $\geq$ 1,5 GPa beträgt.

6. Plasmapolymerer Festkörper, insbesondere plasmapolymere Schicht nach einem der vorangehenden Ansprüche, wobei die Stoffmengenverhältnisse auf der Oberfläche der Schicht gemessen mittel XPS

O : Si 1,0 - 2,0 und/oder
C : Si 1,1 - 2,5

betragen und/oder
wobei für die Stoffmengenanteile auf der Oberfläche der Schicht gemessen mittel XPS gilt:

O : 25 - 50 at%
Si : 22 - 28 at%
C : 28 - 50 at%

jeweils bezogen auf die Gesamtzahl der in der Schicht enthaltenen Atome ohne H.

7. Verwendung eines plasmapolymeren Festkörpers, insbesondere einer plasmapolymeren Schicht wie in einem der Ansprüche 1 bis 6 definiert als Trennschicht in einem Formwerkzeug.

8. Verwendung nach Anspruch 7, wobei die Trennung gegenüber einem Kunststoff, bevorzugt ausgewählt ist aus der Gruppe bestehend aus Elastomer, Thermoplast und Duroplast und/oder weiter bevorzugt gegenüber einem Faserverbundkunststoff erfolgt.

9. Verwendung eines plasmapolymeren Festkörpers, insbesondere einer plasmapolymeren Schicht nach einem der Ansprüche 1 - 6 zur Verbesserung der Reinigungsfähigkeit eines Festkörpers mit Wasser, wässrigen Substanzen, $CO_2$ und/oder Lösungsmitteln.

10. Verwendung eines plasmapolymeren Festkörpers, insbesondere einer plasmapolymeren Schicht wie in einem der Ansprüche 1 bis 6 definiert zur Verbesserung des Korrosionsschutzes einer Oberfläche.
wobei die Oberfläche bevorzugt aus einem Metall oder einer Metalllegierung besteht oder ein Metall oder eine Metalllegierung umfasst,
wobei das Metall oder Metalllegierung weiter bevorzugt ausgewählt ist aus der Gruppe bestehend aus Eisen, Aluminium, Magnesium, Kupfer Silber, Nickel, Zink, Titan und deren Legierungen.

11. Festkörper, umfassend ein Substrat sowie einen plasmapolymeren Festkörper, insbesondere eine plasmapolymere Beschichtung nach einem der Ansprüche 1 - 6.

12. Festkörper nach Anspruch 11, wobei das Substrat besteht aus oder umfasst an seiner Oberfläche ein Metall oder eine Metalllegierung und die Beschichtung im Bereich des Metalls oder der Metalllegierung angebracht ist und wobei der
Festkörper bevorzugt ausgewählt aus der Gruppe bestehend aus Wärmeüberträger, Automobilfelge, Möbelbeschlag, Auszugsschiene, Automobilzier- oder Funktionselement, medizinisches Gerät, oder Werkzeug und Geländer.

13. Festkörper nach Anspruch 11, ausgewählt aus der Gruppe bestehend aus Vorrichtung zur Formgebung von FVK oder anderen Kunststoffen, Presse, Umformwerkzeug, Spritzgusswerkzeug, Gießwerkzeug, statische Dichtungen, Komponenten von Klebstoffapplikationsvorrichtung, Pfannen und anderen Garvorrichtungen, Photovoltaikmodulen und anderen stromerzeugenden Elementen, Bauelementen für die Verpackungsindustrie, wie z.B. Schieber oder Transportelemente, Komponenten von Lackier- und Druckvorrichtungen, wie z.B. Rohrleitungen, Abdeckungen oder Farbbehälter.

**Claims**

1. Solid-state plasma polymer body, especially plasma polymer layer, wherein the lower limit of the modulus of elasticity of the coating is determined by the following function (1):

$$E = 25 - 31.5 * x + 13.5 * x^2 - 1.85 * x^3 \qquad (1)$$

with

x = C/O ratio determined by means of XPS
E = modulus of elasticity [GPa]
when E $\geq$ 1.25 GPa and
x $\geq$ 0.5 and $\leq$ 2.0,

where the following applies to the maximum of the Si 2p peak on the surface of the layer, measured by means of XPS:

when modulus of elasticity < 10 GPa: 102.5 - 102.8 eV when modulus of elasticity 10-20 GPa: 102.7 - 103.1 eV and preferably
when modulus of elasticity > 20 GPa: > 103.0 eV.

2. Solid-state plasma polymer body, especially plasma polymer layer, according to Claim 1, wherein the maximum polar component of the surface energy of the surface is determined by the following functions (2) or (2a):

$$\sigma(p) = 0.28 * E + 0.106 \qquad (2)$$

or

$$\sigma(p) = 1.2 \qquad\qquad (2a),$$

whichever value of the functions (2) and (2a) is the greater,
with

$\sigma(p)$ = polar component of the surface energy [mN/m]
E = modulus of elasticity [GPa]
when E = 1.25 - 30

and/or
the surface energy of the surface, in terms of its upper limit, is determined by the following function (3) :

$$\sigma = 0.9 * E + 21.7 \qquad (3)$$

and the surface energy of the surface, in terms of its lower limit, is determined by the following function (4):

$$\sigma = 0.25 * E + 22.25 \qquad (4)$$

with

$\sigma$ = surface energy [mN/m]
E = modulus of elasticity [GPa].

3. Solid-state plasma polymer body, especially plasma polymer layer, according to Claim 1 or 2, wherein the surface has a refractive index at 550 nm of 1.4 to 1.54.

4. Solid-state plasma polymer body, especially plasma polymer layer, according to any of the preceding claims, wherein the layer has a layer thickness of 5 nm - 20 $\mu$m, preferably 200 nm - 10 $\mu$m and more preferably 400 nm - 5 $\mu$m.

5. Solid-state plasma polymer body, especially plasma polymer layer, according to any of the preceding claims, wherein the hardness of the layer measured by means of nanoindentation is $\geq$ 0.5 GPa, preferably $\geq$ 1 GPa, further preferably $\geq$ 1.5 GPa.

6. Solid-state plasma polymer body, especially plasma polymer layer, according to any of the preceding claims, wherein the molar ratios on the surface of the layer measured by means of XPS are

O:Si 1.0 - 2.0 and/or
C:Si 1.1 - 2.5

and/or
where the following applies to the molar proportions on the surface of the layer measured by means of XPS:

O: 25 - 50 at%
Si: 22 - 28 at%
C: 28 - 50 at%

based in each case on the total number of atoms present in the layer excluding H.

7.  Use of a solid-state plasma polymer body, especially a plasma polymer layer, as defined in any of Claims 1 to 6 as separation layer in a mould.

8.  Use according to Claim 7, wherein the separation is against a plastic, preferably selected from the group consisting of elastomer, thermoplastic and thermoset, and/or further preferably against a fibre composite plastic.

9.  Use of a solid-state plasma polymer body, especially a plasma polymer layer, according to any of Claims 1 - 6, for improving the cleanability of a solid-state body with water, aqueous substances, $CO_2$ and/or solvents.

10. Use of a solid-state plasma polymer body, especially a plasma polymer layer, as defined in any of Claims 1 to 6 for improving the anticorrosive properties of a surface,
    wherein the surface preferably consists of a metal or metal alloy or comprises a metal or metal alloy, wherein the metal or metal alloy is further preferably selected from the group consisting of iron, aluminium, magnesium, copper, silver, nickel, zinc, titanium and alloys thereof.

11. Solid-state body comprising a substrate and a solid-state plasma polymer body, especially a plasma polymer coating, according to any of Claims 1 - 6.

12. Solid-state body according to Claim 11, wherein the substrate consists of or comprises, on its surface, a metal or metal alloy and the coating is in the region of the metal or metal alloy, and wherein the solid-state body is preferably selected from the group consisting of heat transferers, automotive wheel rims, furniture decoration, pull-out rails, automotive decorative or functional elements, medical equipment, or tools and railings.

13. Solid-state body according to Claim 11, selected from the group consisting of device for shaping FRPs or other plastics, press, forming mould, injection mould, casting mould, static seals, components of adhesive application device, pans and other cooking devices, photovoltaic modules and other power-generating elements, components for the packaging industry, for example conveyors or transport elements, components of painting and printing devices, for example conduits, covers or ink vessels.

**Revendications**

1.  Corps solide de polymère de plasma, en particulier couche de polymère de plasma, dans lequel la limite inférieure du module d'élasticité du revêtement est définie par la fonction (1) suivante :

$$E = 25 - 31{,}5 * x + 13{,}5 * x^2 - 1{,}85 * x^3 \qquad (1)$$

    avec

    x = rapport C/O déterminé au moyen d'une spectrométrie XPS
    E = module d'élasticité [GPa]
    pour E ≥ 1,25 GPa et
    x ≥ 0,5 et ≤ 2,0

    dans lequel s'applique sur la surface de la couche, d'après une mesure au moyen d'une spectrométrie XPS pour le maximum du pic Si 2p :

    pour le module d'élasticité < 10 GPa : 102,5 - 102,8 eV
    pour le module d'élasticité 10 - 20 GPa : 102,7 - 103,1 eV et de manière préférée
    pour le module d'élasticité > 20 GPa : > 103,0 eV.

2.  Corps solide de polymère de plasma, en particulier couche de polymère de plasma selon la revendication 1, dans lequel la fraction polaire maximale de l'énergie superficielle de la surface est définie par des fonctions (2) ou (2a) suivantes :

$$\sigma(p) = 0.28 * E + 0.106 \qquad (2)$$

ou

$$\sigma(p) = 1.2 \qquad (2a)$$

en fonction de la valeur des fonctions (2) et (2a), qui est la plus grande,
avec

$\sigma(p)$ = fraction polaire de l'énergie superficielle [mN/m]
E = module d'élasticité [GPa]
pour E = 1,25 - 30

et/ou
l'énergie superficielle de la surface eu égard à sa limite supérieure est définie par la fonction (3) suivante :

$$\sigma = 0.9 *E + 21.7 \qquad (3)$$

et l'énergie superficielle de la surface eu égard à sa limite inférieure est définie par la fonction (4) suivante :

$$\sigma = 0.25 *E + 22.25 \qquad (4)$$

avec

$\sigma$ = énergie superficielle [mN/m]
E = module d'élasticité [GPa].

3. Corps solide de polymère de plasma, en particulier couche de polymère de plasma, selon la revendication 1 ou 2, dans lequel la surface dispose d'un indice de réfraction pour 550 nm de 1,4 à 1,54.

4. Corps solide de polymère de plasma, en particulier couche de polymère de plasma, selon l'une quelconque des revendications précédentes, dans lequel la couche possède une épaisseur de couche de 5 nm - 20 $\mu$m, de manière préférée 200 nm - 10 $\mu$m et de manière particulièrement préférée de 400 nm - 5 $\mu$m.

5. Corps solide de polymère de plasma, en particulier couche de polymère de plasma, selon l'une quelconque des revendications précédentes, dans lequel la dureté de la couche d'après une mesure au moyen d'une nanoindentation est $\geq$ 0,5 GPa, de manière préférée $\geq$ 1 GPa, de manière davantage préférée $\geq$ 1,5 GPa.

6. Corps solide de polymère de plasma, en particulier couche de polymère de plasma, selon l'une quelconque des revendications précédentes, dans lequel les rapports de quantités de matière sur la surface de la couche d'après une mesure au moyen d'une spectrométrie XPS sont

O : Si 1,0 - 2,0 et/ou
C : Si 1,1 - 2,5,

et/ou
dans lequel s'applique pour les fractions de quantités de matières sur la surface de la couche d'après une mesure au moyen d'une spectrométrie XPS :

O : 25 - 50 % at
Si : 22 - 28 % at
C : 28 - 50 % at

respectivement par rapport au nombre total des atomes sans H contenus dans la couche.

**7.** Utilisation d'un corps solide de polymère de plasma, en particulier d'une couche de polymère de plasma, tel que défini dans l'une quelconque des revendications 1 à 6 en tant que couche de séparation dans un outil de moulage.

**8.** Utilisation selon la revendication 7, dans laquelle la séparation est effectuée par rapport à une matière plastique de manière préférée choisie parmi le groupe constitué d'un élastomère, d'une matière thermoplastique et d'une matière thermodurcissable et/ou de manière davantage préférée par rapport à une matière plastique composite à base de fibres.

**9.** Utilisation d'un corps solide de polymère de plasma, en particulier d'une couche de polymère de plasma, selon l'une quelconque des revendications 1 - 6 pour améliorer la capacité de nettoyage d'un corps solide avec de l'eau, des substances aqueuses, du $CO_2$ et/ou des solvants.

**10.** Utilisation d'un corps solide de polymère de plasma, en particulier d'une couche de polymère de plasma, tel que défini dans l'une quelconque des revendications 1 à 6 pour améliorer la protection anticorrosion d'une surface,
dans laquelle la surface est constituée de manière préférée d'un métal ou d'un alliage métallique ou comprend un métal ou un alliage métallique,
dans laquelle le métal ou l'alliage métallique est choisi de manière davantage préférée parmi le groupe constitué du fer, de l'aluminium, du magnésium, du cuivre, de l'argent, du nickel, du zinc, du titane et de leurs alliages.

**11.** Corps solide comprenant un substrat ainsi qu'un corps solide de polymère de plasma, en particulier un revêtement de polymère de plasma, selon l'une quelconque des revendications 1 - 6.

**12.** Corps solide selon la revendication 11, dans lequel le substrat est constitué de ou comprend sur sa surface un métal ou un alliage métallique et le revêtement est appliqué dans la zone du métal ou de l'alliage métallique et dans lequel le corps solide est choisi de manière préférée parmi le groupe constitué d'un échangeur de chaleur, d'une jante automobile, d'une ferrure de meuble, d'un rail d'extraction, d'un élément décoratif automobile ou fonctionnel, d'un appareil médical ou d'un outil et d'un garde-corps.

**13.** Corps solide selon la revendication 11, choisi parmi le groupe constitué d'un dispositif de façonnage de matières plastiques renforcées par des fibres ou d'autres matières plastiques, d'une presse, d'un outil de refaçonnage, d'un outil de moulage par injection, d'un outil de coulée, de joints d'étanchéité statiques, de composants de dispositif d'application de colle, de poêles et d'autres dispositifs de cuisson, de modules photovoltaïques et d'autres éléments de production de courant, de composants pour l'industrie de l'emballage tels que des tiroirs ou des éléments de transport, de composants de dispositifs de peinture et d'impression, tels que des conduits tubulaires, des recouvrements ou des réservoirs de peinture/d'encre.

Fig. 1

**Fig. 2**

**Fig. 3**

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010125178 A1
- DE 102009000699 A1
- EP 1301286 B1
- US 7622400 B1
- DE 102009054893 A1
- DE 102012207149
- EP 0841140 A2
- DE 10034737 A1
- DE 102006018491 A1
- DE 102005059706 A1
- DE 10131156 A1
- DE 102009002780 A1
- DE 102007000611 A1

- WO 2007118905 A1
- DE 102005014617 A1
- US 2010239783 A1
- DE 10034737
- DE 19748240 A1
- DE 10200700611 A1
- JP 63235463 A
- JP 2154993 A
- WO 02059391 A1
- WO 02059051 A2
- WO 9701656 A1
- WO 03002269 A

**In der Beschreibung aufgeführte Nicht-Patentliteratur**

- **W.C. OLIVER ; G.M. PHARR.** An improved technique for determining hardness and elastic modulus using load and displacement sensing indentation experiments. *J. Material Res.,* 1992, vol. 7 (6), 1564-1583
- **K. I. SCHIFFMANN ; R. L.A. KÜSTER.** Comparison of Hardness and Young's Modulus by Single Indentation and Multiple Unloading Indentation. *Zeitschrift für Metallkunde,* 2004, vol. 95 (5), 311-316

- **S. WU.** Calculation of interfacial tension in polymer systems. *Journal of Polymer Science,* 1971, vol. 34 (1), 19-30
- **VISSING, K.** *Aufskalierung plasmapolymerer Beschichtungsverfahren, Dissertation, Culliver,* 2008, ISSN 978-3-86727-548-4